# EUROPÄISCHE PATENTSCHRIFT

(11) **EP 1 175 774 B1**
(45) Veröffentlichungstag und Bekanntmachung des Hinweises auf die Patenterteilung: **21.05.2003**
(21) Anmeldenummer: 00922578.0
(22) Anmeldetag: 30.03.2000
(51) Int. Cl.: H04N 3/15, H03F 3/72

(54) **SCHALTUNG ZUM VERARBEITEN EINES ZEITDISKRETEN ANALOGSIGNALS UND BILDSENSOR**
CIRCUIT FOR PROCESSING A TIME-DISCRETE ANALOG SIGNAL AND IMAGE SENSOR
CIRCUIT POUR LE TRAITEMENT D'UN SIGNAL ANALOGIQUE TEMPOREL DISCRET ET CAPTEUR D'IMAGES

(30) Priorität: 20.04.1999 DE 19917863
(43) Veröffentlichungstag der Anmeldung: 30.01.2002
(73) Patentinhaber: Fraunhofer-Gesellschaft zur Förderung der angewandten Forschung e.V., 80636 München (DE)
(72) Erfinder: BELLINGRATH, Thomas, D-90409 Nürnberg (DE); HACKNER, Michael, D-91052 Erlangen (DE)
(74) Vertreter: Schoppe, Fritz, Dipl.-Ing.
(86) Internationale Anmeldenummer: EP0002834
(87) Internationale Veröffentlichungsnummer: WO00064142

(56) Entgegenhaltungen:
- EP-A- 0 952 730
- US-A- 5 541 553
- US-A- 5 869 857
- US-A- 6 043 525

## Beschreibung

Die vorliegende Erfindung bezieht sich allgemein auf die Verarbeitung von Analogsignalen und insbesondere auf die Verarbeitung von zeitdiskreten Analogsignalen, wie sie beispielsweise am Ausgang eines Bildsensors mit einer Mehrzahl von Pixelzellen auftreten.

Es existieren viele Anwendungen, bei denen Analogsignale schnell und mit hoher Genauigkeit verarbeitet werden müssen. Allgemein kann festgehalten werden, daß die Zeit, die der Ausgang einer Verstärkerstufe mindestens benötigt, um einen Spannungswert mit vorgegebener Genauigkeit zu erreichen, von einer an dem Ausgang vorhandenen Lastkapazität und von dem zur Umladung dieser Lastkapazität zur Verfügung stehenden Strom abhängt.

Im Stand der Technik wird, um einen schnellen Verstärker zu erhalten, in erster Linie die Lastkapazität der Verstärkerstufe, die sich oftmals aus parasitären Kapazitäten und Leitungskapazitäten zusammensetzt, minimiert. Darüber hinaus wird der maximale Ausgangsstrom der treibenden Stufe, der zum Umladen der Lastkapazität benötigt wird, durch zeitlich konstante oder auch signalabhängige Erhöhung des Querstroms, d. h. des Gleichstroms für einen bestimmten Arbeitspunkt, durch die Ausgangsstufe erhöht.

Problematisch ist, daß die Minimierung der Lastkapazität oft durch Spezifikationsvorgaben oder durch die physikalische Anordnung der Schaltungsteile und die damit einhergehende Leitungskapazität begrenzt ist. Andererseits ist die Erhöhung des maximal möglichen Ausgangsstroms durch zeitlich konstante Erhöhung des Querstroms wegen der damit anwachsenden Verlustleistung ebenfalls begrenzt. Eine signalabhängige Erhöhung des Querstroms hingegen erfordert besondere schaltungstechnische Maßnahmen, die vielfach andere Einschränkungen nach sich ziehen. Wenn ein Paar von Gegentaktsourcefolgern bzw. Gegentaktemitterfolgern betrachtet wird, bei denen der jeweils komplementäre Transistor als Last für den anderen dient, verringert sich die Ausgangsaussteuerbarkeit der Gesamtschaltung. Andere Maßnahmen zur signalabhängigen Erhöhung des Querstroms erhöhen den Schaltungsaufwand und können einen ungünstigen Einfluß auf die Bandbreite und Temperaturstabilität der Schaltung haben.

Zeitdiskrete Analogsignale sind besondere analoge Signale, die in einem bestimmten Intervall einen im wesentlichen konstanten Pegel haben, der theoretisch unmittelbar auf einen anderen konstanten Pegel in einem nächsten Intervall springt. Wenn solche zeitdiskreten Analogsignale mit realen Schaltungen, die eine inhärente Tiefpaßcharakteristik haben, verarbeitet werden, so führt dies dazu, daß die theoretisch unendlich steilen Flanken an den Intervallgrenzen flacher werden und sich der zeitdiskrete Signalpegel eines Intervalls nicht schon am Rand des Intervalls sondern erst nach einer bestimmten "Einschwingzeit" einstellt. Erst wenn sich der Pegel eingestellt hat, ist das zeitdiskrete Analogsignal aussagekräftig, weshalb dieser Abschnitt des Intervalls als informationstragender Abschnitt des zeitdiskreten Analogsignals bezeichnet wird.

Bildsensoren, die seriell ausgelesen werden, liefern beispielsweise ein solches zeitdiskretes Analogsignal. Wenn ein Bildsensor mit einer Zeile von 512 Pixeln betrachtet wird, so werden die 512 Pixel nacheinander, gesteuert durch ein Taktsignal, ausgelesen, so daß sich am Ausgang des Bildsensors ein zeitdiskretes Analogsignal ergibt, das in seinem ersten Intervall einen Beleuchtungswert des ersten Pixels darstellt und in seinem letzten Intervall einen Beleuchtungswert des 512-ten Pixels darstellt. Selbstverständlich könnte ein solcher Sensor mehrere Ausgänge haben, derart, daß keine vollständig serielle Auslesung stattfindet, sondern eine gemischte seriell/parallele Auslesung. Üblicherweise kann jedoch davon ausgegangen werden, daß ein Bildsensor im allgemeinen weniger Analogausgänge als Bildpunkte aufweist. Daher müssen die Analogwerte mehrere Bildpunkte durch Multiplexverfahren mit möglichst hoher Rate über die Ausgänge des Bildsensors übertragen werden. Damit ergibt sich das beschriebene zeitdiskrete Analogsignal, das auch als ein kontinuierliches Signal aufgefaßt werden kann, das aus stückweise konstanten Signalteilen zusammengesetzt ist.

Üblicherweise werden konventionelle Verstärkerschaltungen, wie z. B. kontinuierlich betriebene Sourcefolger- oder Emitterfolgerschaltungen eingesetzt, um solche zeitdiskreten Analogsignale zu verarbeiten bzw. eine externe und/oder interne Lastkapazität zu treiben. Solche Sourcefolger- oder Emitterfolgerverstärkerstufen basieren auf Transistoren mit signalabhängigem dynamischem Arbeitspunkt (AB-Betrieb). Ein Nachteil an einem solchen zeitkontinuierlich betriebenen Sourcefolger bzw. Emitterfolger ist die Tatsache, daß der Betrag des Ausgangsstroms für eine Ausgangsstromrichtung durch den "vorgegebenen" Querstrom, d. h. im AB-Betrieb durch das Signal vorgegebenen Querstrom, durch die Transistorstufe begrenzt ist. Würde der vorgegebene Querstrom einfach erhöht werden, um die Stufe schneller zu machen, so würde damit die Verlustleistung der Verstärkerstufe auf inakzeptabel hohe Werte ansteigen.

Die JP 62-220010 offenbart eine Schaltung zum selektiven Verringern eines Basispotentials eines zweiten Transistors, dessen Basis mit einem Ausgangsknoten eines ersten Transistors verbunden ist. Zwischen dem Ausgangsknoten des ersten Transistors und einem Massepotential befindet sich eine Stromquelle. Der erste Transistor, der als npn-Transistor ausgeführt ist, ist derart verschaltet, daß sein Emitteranschluß mit dem Ausgangsknoten verbunden ist, daß sein Kollektoranschluß mit einer Batteriespannung verbunden ist, und daß an den Basisanschluß des npn-Transistors ein Eingangspotential anlegbar ist.

Die JP-07245536-A offenbart eine Verstärkerschaltung mit einer Ausgangssteuerfunktion, wobei diese Schaltung eine invertierte Darlington-Schaltung verwendet. Die Darlington-Schaltung besteht aus einem ersten Transistor und einem zweiten Transistor, wobei der Emitteranschluß des ersten Transistors über einen Schalter mit dem Kollektoranschluß des zweiten Transistors verbunden ist. Ferner ist der Kollektoranschluß des ersten Schalters über eine Spannungsversorgung verbunden, die wiederum mit dem Emitteranschluß des zweiten Transistors in Verbindung steht. Der Eingangsanschluß der Schaltung wird durch den Basisanschluß des ersten Transistors gebildet, während der Ausgangsanschluß der Schaltung durch den Kollektoranschluß des zweiten Transistors gebildet wird.

Die nachveröffentlichte EP 0952730 A2 offenbart eine Festkörperbilderfassungsvorrichtung, bei der ein Pixel eine Photodiode, einen Transferschalter, einen Rücksetzschalter, einen Pixelverstärker und einen Reihenauswahlschalter umfaßt. Durch den Reihenauswahlschalter wird der Pixelverstärker mit einem Knoten verbunden, um mit einer zwischen Source und Masse liegenden Stromquelle als Source-Folger zu arbeiten. Ist der Reihenauswahlschalter nicht geöffent, so arbeitet der Pixelverstärker im Triodenbetrieb, um an seiner Gatekapazität eine möglichst große Ladung der Photodiode aufzunehmen. Zwischen dem Source-Anschluß des Pixelverstärkers und einer Signalspeichereinheit sind Transfer-Gatter vorgesehen. Ferner ist der Source-Anschluß des Pixelverstärkers über einen Rücksetzschalter mit Masse verbindbar. Der Rücksetzschalter und die Transfer-Gatter werden so geschaltet, daß die Signalspeichereinheit immer dann von der Stromquelle und dem Source-Anschluß abgetrennt ist, wenn der Rücksetzschalter den Source-Anschluß und die Stromquelle mit der Schaltungsmasse verbindet.

Die Aufgabe der vorliegenden Erfindung besteht darin, eine Schaltung zum Verarbeiten eines zeitdiskreten Analogsignals zu schaffen, die trotz geringem Aufwand eine hohe Schnelligkeit erreicht.

Diese Aufgabe wird durch eine Schaltung nach Patentanspruch 1 oder Patentanspruch 2 gelöst.

Eine weitere Aufgabe der vorliegenden Erfindung besteht darin, einen schnellen Bildsensor zu schaffen.

Diese Aufgabe wird durch einen Bildsensor nach Patentanspruch 17 oder 18 bzw 16 oder 17 für die staaten DE, FR, GB, IT, NL gelöst.

Der vorliegenden Erfindung liegt die Erkenntnis zugrunde, daß für ein schnelles Einschwingen einer Verstärkerstufe auf einen bestimmten Spannungswert neben der Größe der Lastkapazität und neben dem zur Umladung dieser Lastkapazität zur Verfügung stehenden Strom auch der Startwert der Ausgangsspannung zu Beginn des Einschwingvorgangs entscheidend ist. Um eine schnelle Verstärkerstufe zu erhalten, wird daher erfindungsgemäß der Startwert der Ausgangsspannung zu Beginn des Einschwingvorgangs manipuliert, um den Zeitbedarf von Verstärkerstufen für das Einschwingen auf einen Ausgangsspannungswert mit vorgegebener Genauigkeit zu minimieren.

Wie es bereits erwähnt worden ist, wird versucht, den Querstrom einer Emitter- bzw. Sourcefolgerstufe möglichst gering zu halten, um die Verlustleistung des Transistors auf einem erträglichen Maß zu halten. Dies kann einerseits dadurch erreicht werden, daß zwischen dem Emitter bzw. der Source und Masse (npn-Emitterfolger bzw. n-Kanal-FET) bzw. zwischen Emitteranschluß bzw. Sourceanschluß und Betriebsspannungspotential (pnp-Emitterfolger bzw. p-Kanal-FET) ein hochohmiger ohmscher Widerstand vorgesehen ist. Noch günstiger ist es, diesen Widerstand durch eine sehr hochohmige Konstantstromquelle zu ersetzen, da dann nicht der hohe Spannungsabfall auftritt, der an dem hochohmigen Emitterwiderstand vorhanden sein würde. Diese Maßnahme wird vorgesehen, um die Verlustleistung im Transistor, die mit zunehmendem Kollektorstrom bzw. Drainstrom ansteigt, gering zu halten.

Nachteilig ist nun jedoch, daß sich eine Lastkapazität über den hochohmigen Widerstand bzw. die Laststromquelle mit hohem Innenwiderstand entladen bzw. aufladen muß. Dieser Entlade- bzw. Aufladevorgang kann daher nur sehr langsam stattfinden, was die Schnelligkeit der Verstärkerstufe entscheidend beeinflußt. Dagegen findet das Aufladen der Kapazität für einen npn-Emitterfolger oder einen n-Kanal-Sourcefolger bzw. das Entladen für einen pnp-Emitterfolger oder p-Kanal-Sourcefolger schnell statt, da die Kapazität durch die Spannungsversorgungsquelle aufgeladen bzw. entladen wird. Zusätzlich wird der Transistor aufgrund der Tatsache, daß die Eingangsspannung während des Aufladens geringer als die Ausgangsspannung ist, automatisch geöffnet, derart, daß der Transistor "aufgesteuert" wird. Dadurch liefert derselbe einen höheren Ausgangsstrom, als er durch die Laststromquelle bzw. den Emitter- bzw. Sourcewiderstand vorgegeben ist.

Erfindungsgemäß wird einerseits diese dynamische Stromvergrößerung, die das Umladen einer Lastkapazität in einer Richtung beschleunigt, ausgenutzt. Andererseits wird gemäß der vorliegenden Erfindung ein Schalter vorgesehen, der den Ausgangsknoten der erfindungsgemäßen Schaltung, der bei einem Ausführungsbeispiel dem Emitter bzw. der Source entspricht, vorzugsweise am Ende und/oder zu Beginn jedes Intervalls, z. B. vom Ende des vorausgehenden Intervalls bis zum Beginne des folgenden Intervalls mit einem Referenzknoten verbindet, um die Lastkapazität zu entladen (npn-Emitterfolger bzw. n-Kanal-Sourcefolger) bzw. aufzuladen (pnp-Emitterfolger bzw. p-Kanal-Sourcefolger), derart, daß sämtliche Umladevorgänge der Kapazität aufgrund des zeitdiskreten Analogsignals aufgrund des vorher beschriebenen schnellen Effekts stattfinden und keine Umladung der Lastkapazität über einen hochohmigen Widerstand bzw. über eine hochohmige Stromquelle stattfinden muß.

Anschaulich gesprochen wird somit die Ladung auf der Lastkapazität am Ausgangsknoten der Schaltung in einem nicht-informationstragenden Abschnitt jedes Intervalls auf ein Referenzpotential "zurückgesetzt", d. h. auf einen definierten günstigen Startwert gesetzt, von dem aus der schnelle Umladeeffekt stattfinden kann.

Bei einem bevorzugten Ausführungsbeispiel der vorliegenden Erfindung wird ein npn-Emitterfolger bzw. ein n-Kanal-Sourcefolger eingesetzt. In diesem Fall ist das Referenzpotential kleiner oder gleich dem kleinsten Spannungspegel des zeitdiskreten Analogsignals. Bei einem anderen bevorzugten Ausführungsbeispiel der vorliegenden Erfindung wird ein pnp-Emitterfolger bzw. ein p-Kanal-Sourcefolger eingesetzt. In diesem Fall ist das Referenzpotential größer oder gleich dem größten Signalpegel des Analogsignals. Somit sind die Umladevorgänge der Lastkapazität bzw. des Ausgangsknotens der Transistorstufe, die durch das zeitdiskrete Analogsignal am Eingang der Folgerstufe veranlaßt werden, immer die schnellen Umladevorgänge, die durch ein automatisches Auf steuern des Transistors noch beschleunigt werden. Dies ist der Fall, da die Ausgangsspannung der Transistorstufe durch Kurzschließen über den Schalter in einem nicht-informationstragenden Abschnitt jedes Intervalls auf das Referenzpotential gesetzt wird.

Bei einem bevorzugten Ausführungsbeispiel der vorliegenden Erfindung ist ferner ein zweiter Schalter zwischen dem Kollektor- bzw. Drain-Anschluß des jeweiligen Transistors und einem Knoten, an den ein Versorgungspotential angelegt wird, oder zwischen dem Emitter- bzw. Source-Anschluß und dem anderen Knoten, an den das andere Versorgungsspannungspotential angelegt wird, vorgesehen, der im wesentlichen synchron zu dem ersten Schalter betätigt wird, um in der Zeitdauer, in der der Ausgang mit dem Referenzpotential kurzgeschlossen wird, die Spannungsversorgung des Transistors "abzuklemmen", um hohe Querströme durch den Transistor während dieses Zeitpunkts zu verringern, um die Verlustleistung gering zu halten.

Bevorzugte Ausführungsbeispiele der vorliegenden Erfindung werden nachfolgend bezugnehmend auf die beiliegenden Zeichnungen detailliert erläutert. Es zeigen:
- Fig. 1: eine Schaltung gemäß einem ersten Ausführungsbeispiel der vorliegenden Erfindung, die als npn-Emitterfolger ausgeführt ist;
- Fig. 2: eine Schaltung gemäß einem zweiten Ausführungsbeispiel der vorliegenden Erfindung, die als n-Kanal-Sourcefolger ausgeführt ist;
- Fig. 3: eine Schaltung gemäß einem dritten Ausführungsbeispiel der vorliegenden Erfindung, die als pnp-Emitterfolger ausgeführt ist;
- Fig. 4: eine Schaltung gemäß einem vierten Ausführungsbeispiel der vorliegenden Erfindung, die als p-Kanal-Sourcefolger ausgeführt ist;
- Fig. 5: ein Zeitdiagramm von Signalen, wie sie bei der in Fig. 1 gezeigten Schaltung auftreten;
- Fig. 6: ein prinzipielles Blockdiagramm eines erfindungsgemäßen Bildsensors mit schneller Analogsignalverarbeitung; und
- Fig. 7: ein detailliertes Blockdiagramm für ein bevorzugtes Ausführungsbeispiel eines Bildsensors von Fig. 6.

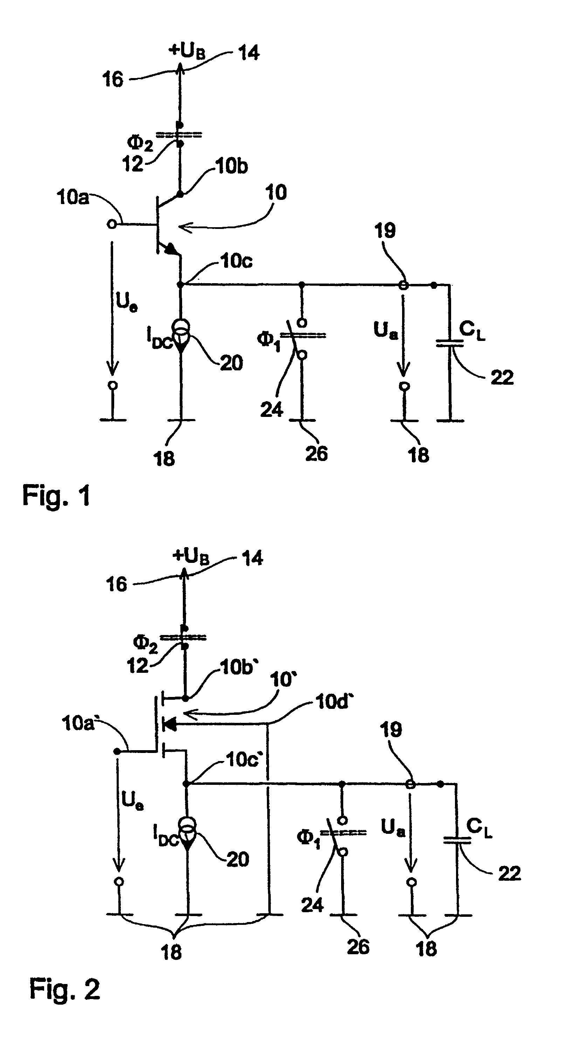

Fig. 1 zeigt eine Schaltung zum Verarbeiten eines Analogsignals Uₑ, das eine zeitliche Folge von diskreten Spannungspegeln aufweist und zu Zwecken der vorliegenden Erfindung als zeitdiskretes Analogsignal bezeichnet wird. Das zeitdiskrete Analogsignal umfaßt eine Mehrzahl von zeitlichen Intervallen, wobei jedem zeitlichen Intervall ein diskreter Signalpegel zugeordnet ist, der einen informationstragenden Abschnitt des entsprechenden Intervalls darstellt, während der Rest des zeitlichen Intervalls ein nicht-informationstragender Abschnitt ist. Das zeitdiskrete Analogsignal Uₑ wird an einen npn-Transistor (10) und insbesondere an ein erstes Tor (10a) des Transistors angelegt, das der Basisanschluß des Transistors (10) ist. Ein zweites Tor (10b) des Transistors, das der Kollektoranschluß desselben ist, ist über einen Schalter (12), auf den später eingegangen wird, mit einer Einrichtung (14) zum Anlegen einer Spannungsversorgung U_{B} verbunden.

An dieser Stelle sei darauf hingewiesen, daß der Ausdruck "Tor" allgemein einen äußeren Zugang zu einem Transistor bedeuten soll, der mit einer Spannung oder einem Strom beaufschlagt werden kann. Wird beispielsweise eine Spannung an das "Basistor" eines Transistors angelegt, so bedeutet dies, daß ein Ausgang der Spannungsquelle mit dem Basisanschluß des Transistors verbunden wird, während der andere Ausgang der Spannungsquelle mit einem Referenzknoten, wie z. B. dem Masseknoten, verbunden wird. Wird ein Strom an das Basistor angelegt, so bedeutet dies, daß ein Anschluß einer Stromquelle mit dem Basisanschluß des Transistors verbunden wird, während der andere Anschluß der Stromquelle mit einem beliebigen Referenzknoten, z. B. Masse, verbunden wird.

Die Einrichtung (14) wird, wenn eine integrierte Schaltung betrachtet wird, ein nach außen geführter Spannungsversorgungspin sein, an den eine externe Spannungsversorgung angeschlossen werden kann. Falls der Chip eine On-Chip-Spannungsversorgung hat, wird die Einrichtung (14) zum Anlegen einer Spannungsversorgung eine interne Leitung in dem Chip sein, die zu der internen Spannungsversorgung U_{B} führt. Über die Einrichtung (14) zum Anlegen einer Spannung kann eine Spannung zwischen einem ersten Knoten (16) und einem zweiten Knoten (18) angelegt werden. Bei dem in Figur 1 dargestellten ersten Ausführungsbeispiel der vorliegenden Erfindung ist der erste Knoten (16) auf Spannungsversorgungspotential +U_{B}, während der zweite Knoten (18) auf Masse liegt.

Zwischen einem dritten Tor (10c) des Transistors (10), das der Emitteranschluß ist, und dem zweiten Knoten (18) (in Fig. 1 Masse) ist eine Laststromquelle I_{DC} (20) geschaltet, die eine Gleichstromquelle ist und den Arbeitspunkt des Transistors (10) definiert. Alternativ könnte statt der Laststromquelle (20) ein Emitterwiderstand vorgesehen sein. Sowohl die Laststromquelle (20) als auch der Emitterwiderstand können als Einrichtung zum Liefern eines Gleichstroms zwischen dem Emitteranschluß (10c) des Transistors (10) und dem Masseknoten (18) aufgefaßt werden. Wenn statt eines hochohmigen Emitterwiderstands eine Konstantstromquelle verwendet wird, kann der hohe Spannungsabfall an dem Emitterwiderstand vermieden werden, wie es für Fachleute bekannt ist.

Einen Ausgangsknoten 19 der in Fig. 1 gezeigten Schaltung bildet der Emitteranschluß (10c) des Transistors (10) zusammen mit dem zweiten Knoten (18), wobei zwischen diesen beiden Knoten eine Ausgangsspannung Uₐ anliegt.

Wie es bekannt ist, folgt die Ausgangsspannung Uₐ der Eingangsspannung Uₑ nach, wobei der Betrag der Ausgangsspannung Uₐ in etwa dem Betrag der Eingangsspannung Uₑ weniger etwa 0,6 V ist. Aus diesem Grund wird diese Schaltung auch als Emitterfolger bezeichnet. Alternativ kann der Emitterfolger auch als Impedanzwandler betrachtet werden, der es erlaubt, eine hochohmige Stufe mit einer niederohmigen Stufe ohne Spannungsverlust zu koppeln.

Üblicherweise ist der Ausgangsknoten 19 einer Verstärkerstufe kapazitiv belastet, was in Fig. 1 und auch in den Fig. 2 bis 4 als Lastkapazität C_{L} dargestellt ist. Diese Lastkapazität C_{L} (22) kann sich einerseits aus einer kapazitiven Impedanz einer nachfolgenden Schaltung oder andererseits aus Leitungskapazitäten oder parasitären Kapazitäten zwischen dem Ausgang und Masse zusammensetzen. Zwecks der Darstellung, jedoch ohne Einschränkung der Allgemeinheit, wird diese Lastkapazität C_{L} (22) in den Figuren als konzentriertes Element behandelt.

Gemäß der vorliegenden Erfindung ist parallel zur Lastkapazität (22) ein erster Schalter (24) vorgesehen, um das dritte Tor (10c), d. h. den Emitteranschluß mit einem Referenzpotential (26) kurzzuschließen, das in Fig. 1 identisch zu dem Massepotential (18) ist. Das Referenzpotential (26) könnte jedoch ebenfalls beispielsweise eine niederohmige Quelle zum Entladen der Lastkapazität (22), beispielsweise in Form einer Betriebsspannungsversorgung oder einer geladenen Kapazität sein.

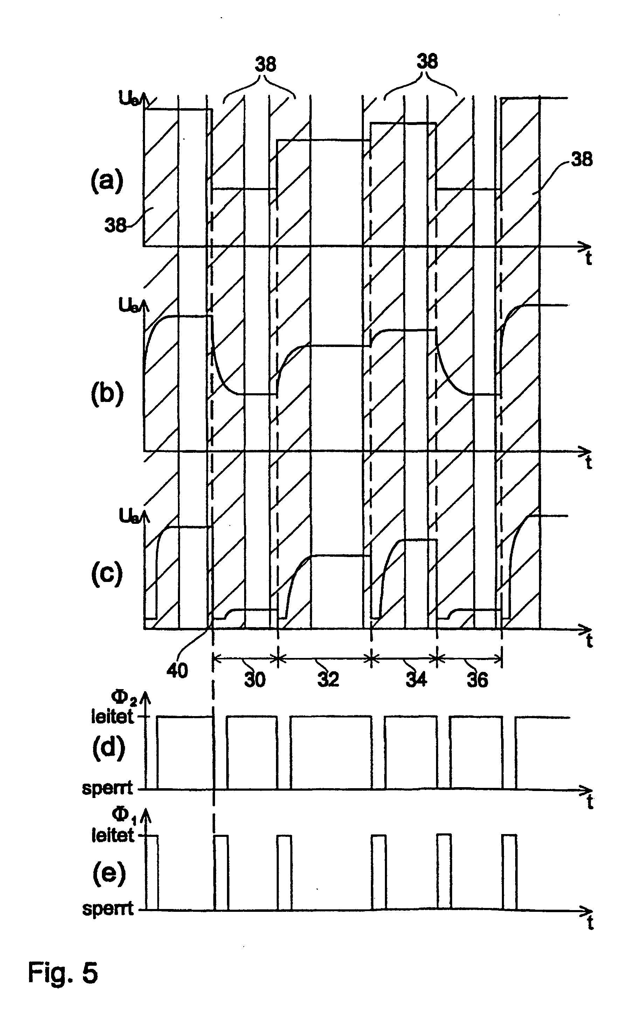

Im nachfolgenden wird auf Fig. 5 Bezug genommen, um die Funktionsweise der in Fig. 1 dargestellten Schaltung gemäß einem ersten Ausführungsbeispiel der vorliegenden Erfindung zu erläutern. Das Teilbild 5 (a) von Fig. 5 stellt ein zeitdiskretes Analogsignal Uₑ über der Zeit t dar, das beispielsweise erhalten wird, wenn ein Bildsensor ideal, d. h. ohne die bei realen Schaltungen immer vorhandene Tiefpaßwirkung ausgelesen wird.

Zur Veranschaulichung sind 4 Intervalle 30, 32, 34, 36 eingezeichnet. Das Teilbild 5 (b) zeigt das selbe zeitdiskrete Analogsignal wie in dem Teilbild 5 (a), das jedoch bereits einer in reellen Schaltungen inhärent vorhandenen Tiefpaßwirkung unterzogen worden ist, weshalb die Übergänge von einem Intervall zum nächsten nicht mehr unendlich steil sind, sondern einen gewissen flacheren bzw. gekrümmten Verlauf haben. Das Teilbild 5 (c) stellt im Gegensatz zu den Teilbildern 5 (a) und 5 (b) den korrespondierenden Verlauf der Ausgangsspannung Uₐ zwischen dem Ausgangsknoten 19 (Fig. 1) und Massepotential 18 dar. Die in den Teilbildern 5 (a), 5 (b) und 5 (c) eingezeichneten schraffierten Bereiche (38) stellen die nicht-informationstragenden Abschnitte des Signalverlaufs dar, wobei zu sehen ist, daß dieselben um die Intervallgrenzen herum angeordnet sind, von denen von vorneherein bekannt ist, daß die dort vorkommenden Spannungswerte unbestimmt sind, da sie einem Einschwingverlauf unterzogen sind, wie er beispielsweise in dem Teilbild 5 (b) für die Eingangsspannung Uₑ dargestellt ist. Aus Zuverlässigkeitsgründen wegen real auftretenden Timing-Toleranzen erstrecken sich die Bereiche 38 nicht nur von einer Intervallgrenze nach rechts, sondern auch von einer Intervallgrenze nach links, derart, daß die informationstragenden, nicht-schraffierten Abschnitte verbleiben, die dadurch gekennzeichnet sind, daß in ihnen der jeweilige Signalpegel des zeitdiskreten Analogsignals im wesentlichen konstant ist. Lediglich die informationstragenden Abschnitte der Intervalle 30, 32, 34, 36 sind für eine Informationsauswertung von Belang, jedoch nicht die nicht-informationstragenden schraffiert eingezeichneten Abschnitte 38 und der schraffiert eingezeichnete Abschnitt eines dem Intervall 30 vorausgehenden Intervalls .

Im nachfolgenden wird die linke Kante des Intervalls 30 betrachtet. Links von der linken Kante des Intervalls 30 befindet sich das Eingangssignal Uₑ und daher auch das Ausgangssignal Uₐ auf einem hohen Pegel. Das Eingangssignal Uₑ nimmt dann in dem Intervall 30 einen niedrigen Pegel an, den auch das Ausgangssignal Uₐ möglichst schnell einnehmen soll. Dazu muß bezugnehmend auf Fig. 1 die Lastkapazität C_{L} 22 auf den niedrigen Pegel des Ausgangssignals Uₐ im Intervall 30 entladen werden. Aus Fig. 1 ist zu sehen, daß diese Entladung lediglich über die hochohmige Laststromquelle 20 bzw. einen alternativ vorhandenen hochohmigen Emitterwiderstand möglich ist. Die Entladung würde daher sehr langsam stattfinden, was die Schnelligkeit der Emitterfolgerstufen gemäß dem Stand der Technik entscheidend beeinträchtigt. Erfindungsgemäß wird nun in dem nicht-informationstragenden Abschnitts des Intervalls 30 der Schalter 24 kurzgeschlossen, derart, daß die Ladung des Lastkondensators 22, die zu der angelegten Spannung Uₐ aus dem Intervall vor dem Intervall 30 proportional ist, zum Referenzpotential 26 abfließen kann. Diese Entladung findet sehr schnell statt, da eine im Vergleich zur Laststromquelle niederohmige "Kurzschluß"-Verbindung durch den Schalter 24 hergestellt wird. An dieser Stelle sei darauf hingewiesen, daß der Ausdruck "Kurzschluß" nicht dahingehend zu verstehen ist, daß ein Widerstand von 0 Ohm vorhanden ist. Wird der Schalter als Transistor realisiert, so könnte er im geschlossenen Zustand durchaus einen On-Widerstand im Bereich einiger hundert Ohm haben. Dieser Wert ist jedoch im Vergleich zum Widerstand der Stromquelle bzw. zu einem sehr hochohmigen Emitterwiderstand klein und kann daher der Übersichtlichkeit halber als "Kurzschluß" bezeichnet werden.

Wenn der Schalter 24 wieder geöffnet wird, d. h. die Verbindung wieder unterbrochen wird, kann sich an dem Emitter 10c des Transistors 10 wieder eine Ausgangsspannung aufbauen, indem die Lastkapazität C_{L} 22 aufgeladen wird.

Diese Aufladung wird dynamisch verstärkt, da der Transistor 10 aufgesteuert wird. Wenn der einfache Fall betrachtet wird, daß die Ausgangsspannung Uₐ durch die Betätigung des Schalters 24 auf Masse entladen wird und eine bestimmte Eingangsspannung Uₑ angelegt wird, so führt dies dazu, daß die Emitterspannung zunächst auf 0 Volt ist, weshalb eine große Basis-Emitter-Spannung anliegt und der Transistor einen großen Stromfluß vom Kollektoranschluß 10b zum Emitteranschluß 10c zuläßt, der den Kondensator C_{L} 22 auflädt. Mit steigender Ausgangsspannung Uₐ wird der Transistor 10 immer mehr gesperrt, da die Basis-Emitter-Spannung immer weiter abnimmt, bis der Transistor wieder den durch die Stromquelle definierten Arbeitspunkt erreicht hat. Durch den dynamischen Effekt wurde jedoch erreicht, daß der Kondensator C_{L} 22 schneller aufgeladen wird als es durch die Konstantstromquelle 20 allein möglich ist. Damit ist zu sehen, daß das Aufladen der Lastkapazität 22 aufgrund der dynamischen Stromvergrößerung ein schneller Vorgang ist. Zu Beginn des Intervalls 32 wird der Kondensator C_{L} wieder durch kurzes Schließen des Schalters 24 entladen, um dann auf den Pegel geladen zu werden, der für den informationstragenden Teil des Intervalls 32 vorgesehen ist. Zu Beginn des Intervalls 34 wird der Kondensator 22 wieder entladen, um dann nach Öffnen des Schalters 24 wieder auf den informationstragenden Wert des Intervalls 34 aufgeladen zu werden. Somit wird der Kondensator in einem nicht-informationstragenden Abschnitt zu Beginn jedes Intervalls immer auf einen Startwert gesetzt, der sicherstellt, daß in im wesentlichen jedem Intervall eine Aufladung des Kondensators C_{L} auf den entsprechenden diskreten Signalpegel stattfindet. Für das Steuersignal des Schalters 24, das als Φ₁ bezeichnet wird, ergibt sich ein Verlauf, wie er in Teilbild 5(e) dargestellt ist.

Damit im Intervall, in dem der Schalter 24 geschlossen ist, kein zu großer Strom von dem Knoten 16 zum Knoten 26 über den Transistor fließt, wodurch die Verlustleistung erhöht wird, wird der zweite Schalter 12 durch ein Signal gesteuert, das als Φ₂ bezeichnet wird und in Teilbild 5(d) dargestellt ist. Um sicherzustellen, daß der Schalter 12 auf jeden Fall geöffnet ist, wenn der Schalter 24 geschlossen wird, wird es bevorzugt, daß die Öffnungszeit des Schalters 12 etwas größer ist als die Schließzeit des Schalters 24. Die beiden Steuersignale Φ₁ und Φ₂ für die beiden Schalter 24 und 12 müssen daher nicht vollständig komplementär zueinander sein.

In Fig. 1 ist das Bezugspotential an dem Bezugsknoten 26 gleich dem Massepotential an dem Masseknoten 18 eingezeichnet. Dies stellt lediglich eine Alternative dar. Der Bezugsknoten 26 könnte ebenfalls eine niederohmige Spannungsquelle oder ein auf das Bezugspotential geladener Kondensator sein, derart, daß der Kondensator C_{L} 22 nicht in jedem Intervall genau auf 0 V, d. h. Masse, entladen wird, sondern lediglich auf einen Wert, der kleiner als der geringste Wert ist, der erwartungsgemäß in dem zeitdiskreten Analogsignal auftritt. Zahlenmäßig ausgedrückt könnte eine Schaltung, wie sie in Fig. 1 gezeigt ist, eine Batteriespannung U_{B} haben, die ein Potential von +5 V zur Masse erzeugt. Die diskreten Spannungspegel könnten dagegen derart beschaffen sein, daß sie nie kleiner als z. B. 1 V sind. In diesem Fall wird es bevorzugt, den Kondensator nicht immer auf 0 V zu entladen, sondern lediglich auf 1 V. Die niederohmige Spannungsquelle, die das Bezugspotential festlegt, würde in diesem Fall eine Spannungsquelle sein, die auf 1 V eingestellt ist. Dadurch wird sichergestellt, daß der Ausgangskondensator C_{L} 22 nicht zu stark entladen wird, um für eine anschließende Aufladung, obgleich dieselbe schnell vonstatten geht, trotzdem nicht mehr Zeit als nötig zu brauchen. Ein anderer Punkt besteht ferner darin, daß eine beispielsweise mit dem Ausgangssignal Uₐ gespeiste Verstärkerstufe durch die in dem Ausgangssignal Uₐ vorhandenen starken Abfälle und daran anschließenden Aufladevorgänge (Bezugszeichen 40 in Fig. 5) nicht in Sättigung getrieben wird.

In Abweichung von dem in Fig. 5 dargestellten Entladen unter den minimalen zu erwartenden diskreten Signalpegel könnte das Bezugspotential auch ausgewählt werden, um eine Entladung auf einen Spannungspegel zu erreichen, der zwischen dem höchsten und dem niedrigsten zu erwartenden diskreten Signalpegel des zeitdiskreten Analogsignals liegt, wenn beispielsweise sehr viele hohe diskrete Signalpegel erwartet werden und nur einige wenige niedrige. In diesem Fall könnte sich bereits ein Geschwindigkeitsvorteil ergeben, da die überwiegende Mehrzahl der Signalpegel sehr schnell erreicht wird, während nur einige wenige sehr langsam erreicht werden. Daher ist zu sehen, daß das Referenzpotential in bestimmten Grenzen variiert werden kann, die nicht zuletzt von dem zu verarbeitenden zeitdiskreten Analogsignal abhängen. So stellt es lediglich eine bevorzugte Ausführungsform der vorliegenden Erfindung dar, das Referenzpotential kleiner oder gleich dem geringsten zu erwartenden diskreten Pegel des zeitdiskreten Analogsignals zu wählen.

Eine weitere Möglichkeit besteht darin, den Schalter 24 nur derart kurz zu betätigen, daß sich der Kondensator nicht vollständig auf das an dem Referenzknoten 26 tatsächlich anliegende Potential entladen kann, wodurch das Referenzpotential, das nach einem erneuten Öffnen des Schalters 24 an dem Emitter 10c des Transistors 10 anliegt, nicht dem Potential an dem Referenzknoten 26 entspricht sondern entsprechend größer ist. Auch in diesem Fall wird der Lastkondensator C_{L} 22 entladen, jedoch nicht genau auf das Potential an dem Referenzknoten 26 sondern auf ein abhängig von der Schließdauer des Schalters 24 entsprechend höheres Potential.

Alternativ zu dem in Fig. 1 gezeigten Ausführungsbeispiel, bei dem der Schalter 12 zwischen dem Knoten 16 und dem Kollektoranschluß 10b liegt, könnte derselben auch zwischen dem Emitteranschluß 10c und dem Ausgangsknoten 19 vorgesehen sein, um somit ebenfalls den Gleichstromweg durch den Transistor zu unterbrechen, wenn der Schalter 24 geschlossen ist, damit die Verlustleistung gering gehalten werden kann.

Im nachfolgenden wird auf Fig. 2 Bezug genommen, die eine Schaltung gemäß einem zweiten Ausführungsbeispiel der vorliegenden Erfindung zeigt. Bezüglich Fig. 2 und den anderen Figuren sei darauf hingewiesen, daß Teile mit gleichen Bezugszeichen im wesentlichen identisch sind und daher, so sie bereits beschrieben worden sind, nicht noch einmal beschrieben werden.

Im Unterschied zu der in Fig. 1 gezeigten Schaltung umfaßt die in Fig. 2 gezeigte Schaltung keinen npn-Bipolartransistor sondern einen n-Kanal-Feldeffekttransistor 10', der als erstes Tor einen Gateanschluß 10a', als zweites Tor einen Drainanschluß 10b' und als drittes Tor einen Sourceanschluß 10c' aufweist, wobei der Feldeffekttransistor 10' in Fig. 2 als selbstsperrender Typ gezeichnet ist. Alternativ könnte jedoch ebenfalls ein selbstleitender Typ oder ein Sperrschicht-FET eingesetzt werden. In Analogie zu Fig. 1, in der der Bipolartransistor als Emitterfolger gezeichnet ist, ist der in Fig. 2 dargestellte Feldeffekttransistor 10' in Sourcefolgerkonfiguration dargestellt. Derselbe umfaßt ferner einen Bulk-Anschluß 10d', der in üblicher Weise mit dem Massepotential 18 verbunden ist. Die Wirkungsweise der n-Kanal-Sourcefolgerschaltung von Fig. 2 ist zu der bezüglich Fig. 1 beschriebenen Funktionsweise analog.

Alternativ zu dem in Fig. 2 gezeigten Ausführungsbeispiel, bei dem der Schalter 12 zwischen dem Knoten 16 und dem Drainanschluß 10b liegt, könnte derselbe auch zwischen dem Sourceanschluß 10c' und dem Ausgangsknoten 19 vorgesehen sein, um somit ebenfalls den Gleichstromweg durch den Transistor zu unterbrechen, wenn der Schalter 24 geschlossen ist, damit die Verlustleistung gering gehalten werden kann.

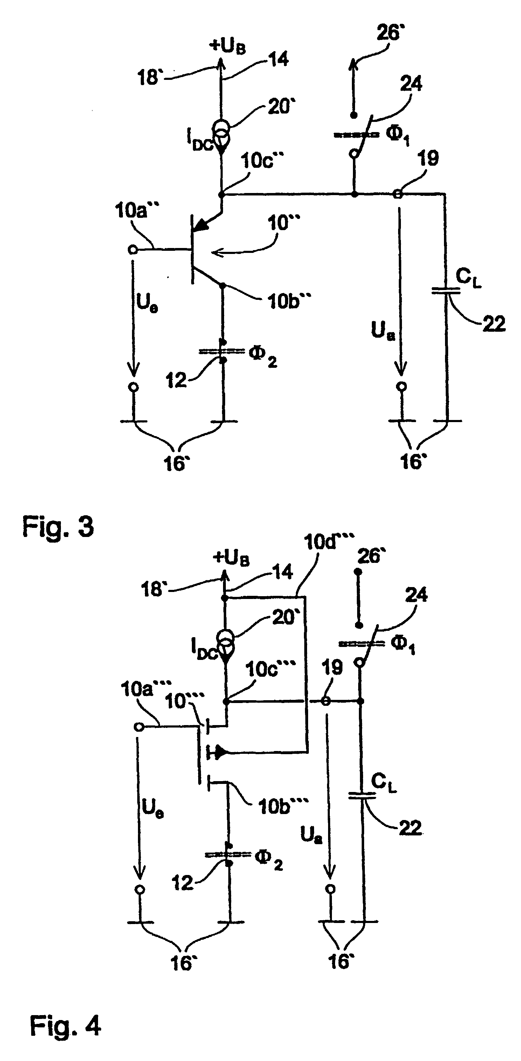

Fig. 3 zeigt eine Schaltung gemäß einem dritten Ausführungsbeispiel der vorliegenden Erfindung, die zu der in Fig. 1 dargestellten Schaltung gemäß dem ersten Ausführungsbeispiel der vorliegenden Erfindung komplementär ist, derart, daß statt des npn-Bipolartransistors ein pnp-Bipolartransistor 10'' verwendet wird. Im Gegensatz zu der in Fig. 1 gezeigten Schaltung ist nun der Emitter 10b'' nicht mit Masse verbunden sondern über die Konstantstromquelle I_{DC} 20' mit dem Spannungsversorgungspotential U_{B}. Dagegen ist nun der Kollektor des pnp-Transistors 10'', d. h. das Tor 10c'', über den Schalter 12 mit dem Massepotential verbunden. Ferner wird, da die in Fig. 3 gezeigte Schaltung komplementär zu der in Fig. 1 gezeigten Schaltung ist, durch den Schalter 24 der Kondensator nicht wie in Fig. 1 auf Masse entladen sondern auf ein Referenzpotential 26' aufgeladen. Dieses Referenzpotential könnte gleich dem Spannungsversorgungspotential sein oder aber ein Potential sein, das größer oder gleich dem höchsten zu erwartenden diskreten Signalpegel des zeitdiskreten Analogsignals ist. Alternativ könnte das Referenzpotential 26' auch kleiner als der höchste zu erwartende Wert sein, wenn in Analogie zu dem vorher beschriebenen nur sehr wenige große diskrete Signalpegel auftreten, derart, daß eine nur kurze und seltene lange Aufladung des Lastkondensators C_{L} 22 in Kauf genommen wird, um den Betrag der Ladung, die meistens für kleinere diskrete Signalpegel entladen werden muß, zu begrenzen. Dies hat ebenso wie vorher beschrieben den Effekt, daß nachfolgende Verstärkerstufen, d. h. Verstärkerstufen, die parallel zu der Lastkapazität C_{L} 22 geschaltet werden, nicht mit hohen Spitzen belastet werden und unter Umständen dadurch in Sättigung getrieben werden.

Das Referenzpotential 26' könnte entweder durch eine Bezugsspannungsquelle geliefert werden, die den für das Referenzpotential gewünschten Spannungswert liefert, oder durch eine auf einen solchen Spannungswert aufgeladene Kapazität, die umso besser arbeitet, je höher die Kapazität eines solchen Kondensators gegenüber der Lastkapazität C_{L} 22 ist. Alternativ kann das Referenzpotential 26' auch durch die Einschaltdauer des Schalters 24 gesteuert werden, derart, daß der Schalter 24 nur sehr kurz geschlossen wird, wodurch das Potential, auf das die positive Elektrode des Kondensators C_{L} 22 auf ein kleineres Potential als an dem Referenzknoten aufgeladen wird. In diesem Fall ist das Potential an dem Referenzknoten derart zu wählen, daß ein gewünschtes Referenzpotential erhalten wird, das beispielsweise größer oder gleich dem höchsten zu erwartenden diskreten Signalpegel ist.

Der Schalter 24 ermöglicht es somit, daß die Kapazität C_{L} 22 sehr schnell auf das Referenzpotential aufgeladen werden kann, da der Strom zum Umladen des Kondensators C_{L} 22 niederohmig zugeführt wird. Damit wird ein langsames Aufladen über die Laststromquelle 20' bzw. alternativ über einen hochohmigen Emitterwiderstand vermieden. Andererseits wird eine Entladung der Kapazität C_{L} 22 über den Transistor 10'' sehr schnell geschehen und sogar dynamisch verstärkt, da der Transistor 10'' "aufgesteuert" wird, wenn die Eingangsspannung Uₑ kleiner als die Ausgangsspannung Uₐ ist. Dies ist der Fall, da die Differenz zwischen Uₑ und Uₐ direkt als Basis-Emitter-Spannung des Transistors 10'' anliegt. Wenn die Ausgangsspannung Uₐ größer als die Eingangsspannung Uₑ ist, so ist diese Spannungsdifferenz negativ, derart, daß der pnp-Transistor 10'' einen höheren Kollektorstrom liefert. Je mehr sich Uₐ an Uₑ annähert, nimmt dieser Effekt ab. Dieser Effekt verschwindet dann, wenn sich Uₐ auf einen dem aktuellen diskreten Spannungspegel Uₑ entsprechenden Wert "eingeschwungen" hat. Somit wird erfindungsgemäß der schnelle Effekt ausgenutzt und der langsame Effekt durch den Schalter 24 eliminiert bzw. ersetzt, derart, daß die Kapazität C_{L} im wesentlichen immer nur von einem Startwert aus entladen wird.

Alternativ zu dem in Fig. 3 gezeigten Ausführungsbeispiel, bei dem der Schalter 12 zwischen dem Knoten 16' und dem Kollektoranschluß 10b liegt, könnte derselben auch zwischen dem Emitteranschluß 10c'' und dem Ausgangsknoten 19 vorgesehen sein, um somit ebenfalls den Gleichstromweg durch den Transistor zu unterbrechen, wenn der Schalter 24 geschlossen ist, damit die Verlustleistung gering gehalten werden kann.

Fig. 4 zeigt eine Schaltung gemäß einem vierten Ausführungsbeispiel der vorliegenden Erfindung, die zu der Schaltung von Fig. 3 bis auf den Unterschied identisch ist, daß statt des pnp-Bipolartransistors 10'' ein p-Kanal-Feldeffekttransistor 10''' vorhanden ist, dessen Bulk-Anschluß bd''' mit dem Spannungsversorgungspotential U_{B} verbunden ist, wie es in der Technik üblich ist. Je nach Technologie kann das Bulk-Potential auch mit dem Sourceanschluß verbunden werden. Obwohl in Fig. 4 ein selbstsperrender Feldeffekttransistor verwendet wird, könnte analog dazu auch ein selbstleitender Typ oder ein Sperrschicht-FET eingesetzt werden.

Alternativ zu dem in Fig. 4 gezeigten Ausführungsbeispiel, bei dem der Schalter 12 zwischen dem Knoten 16' und dem Drainanschluß 10b''' liegt, könnte derselben auch zwischen dem Sourceanschluß 10c''' und dem Ausgangsknoten 19 vorgesehen sein, um somit ebenfalls den Gleichstromweg durch den Transistor zu unterbrechen, wenn der Schalter 24 geschlossen ist, damit die Verlustleistung gering gehalten werden kann.

Obwohl die beiden Schalter 12, 24 bisher allgemein als Schalter beschrieben worden sind, sei darauf hingewiesen, daß dieselben bevorzugterweise als Transistoren realisiert werden, wobei diese Transistoren in gleicher Technologie wie die Transistoren der Folgerstufen ausgeführt sind. Der Transistortyp ist beliebig.

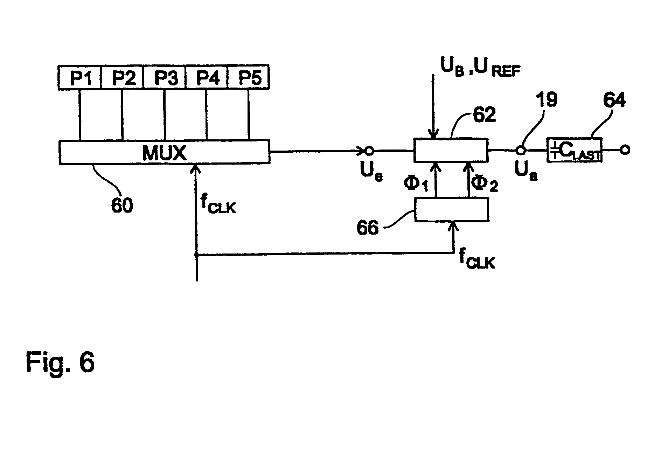

Fig. 6 zeigt eine Anwendung der erfindungsgemäßen Schaltung, die bezugnehmend auf die Fig. 1 bis 5 beschrieben worden ist, in einen Bildsensor. Der Bildsensor, der z. B. ein Zeilensensor für eine Zeilenkamera sein kann, umfaßt eine Mehrzahl von Pixelelementen P1 bis P5. Obwohl in Fig. 6 aus Darstellungsgründen nur fünf Pixelelemente gezeichnet sind, ist es selbstverständlich, daß die Anzahl der Pixelelemente in einem realen Anwendungsfall beliebig ist und von der Implementation abhängt. So können beispielsweise 512 oder 1024 Pixelelemente bei einer Zeilenkamera verwendet werden. Alternativ kann auch ein Array verwendet werden, das aus einer Mehrzahl von Pixelzeilen besteht. Üblicherweise wird jedoch die Anzahl der Ausgangsleitungen kleiner als die Anzahl der Pixelelemente sein, weshalb die Ausgangssignale der einzelnen Pixelelemente über einen Multiplexer 60 parallel/seriell-gewandelt werden, um auf einer Ausgangsleitung des Multiplexers ausgegeben zu werden. An der Ausgangsleitung des Multiplexers 60 liegt dann das zeitdiskrete analoge Signal an, das das Eingangssignal Uₑ für die Schaltung 62 zum schnellen Verarbeiten eines Analogsignals ist, die in Fig. 6 lediglich allgemein gezeichnet ist und bezugnehmend auf die Fig. 1 bis 4 detailliert erläutert worden ist.

Üblicherweise wird am Ausgang der Schaltung 62 irgendeine Lastkapazität anliegen, sei es, daß diese Lastkapazität die Eingangskapazität einer nachfolgenden Verstärkerstufe ist, oder die Kapazität der an dem Ausgang der Schaltung 62 vorhandenen Übertragungsleitungen darstellt oder auch parasitäre Kapazitäten umfaßt. Die Schnelligkeit, mit der die zeitdiskreten Analogsignale ausgegeben werden können, wird daher durch eine kapazitive Belastung des Ausgangs der Schaltung 62 wesentlich beeinflußt. Um eine übersichtliche Schaltungsanordnung beizubehalten, wird versucht, die Anzahl der Ausgangsleitungen aus dem Multiplexer möglichst gering zu halten. Um jedoch gleichzeitig eine hohe Anzahl von Pixelelementen, d. h. Photodioden oder CCD-Pixel, verarbeiten zu können, muß die Auslesefrequenz f_{CLK} sehr hoch gewählt werden. Bei einem Anwendungsbeispiel der vorliegenden Erfindung könnte diese beispielsweise 40 MHz betragen. Dies heißt, daß für einen einzigen zeitdiskreten Analogsignalwert lediglich 25 ns verbleiben. Ein Intervall ist also lediglich 25 ns lang, was dazu führt, daß die Schaltung 62 sehr schnell arbeiten muß, um die Lastkapazität C_{L} 64 immer auf den jeweiligen Wert umzuladen. Die Schaltung 62 umfaßt einen Eingang für das Spannungsversorgungspotential U_{B} und für den Referenzknoten bzw. das Referenzpotential U_{REF} und ist ferner mit einer Zeitsteuerung 66 verbunden, die aus dem Taktsignal mit der Frequenz f_{CLK} Taktsignale Φ₁ und Φ₂ zum Steuern der Schalter 24 und 12 (Fig. 1) erzeugt.

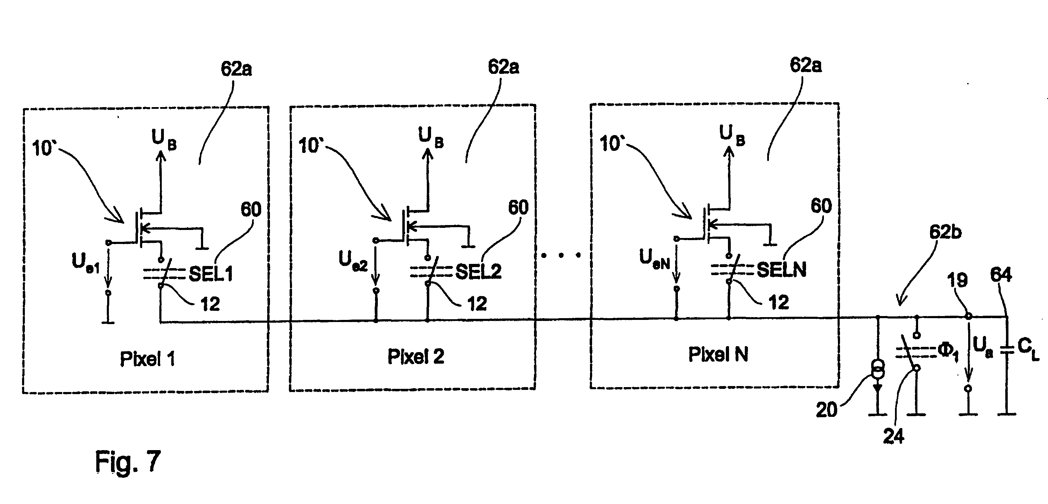

Fig. 7 zeigt ein detailliertes Blockdiagramm für ein bevorzugtes Ausführungsbeispiel eines Bildsensors von Fig. 6. Hierbei ist die erfindungsgemäße Schaltung 62 so aufgetrennt, daß ein Teil 62a davon, d. h. die Spannungsquelle 14 und der Transistor 10' (Fig. 2), "gemultiplext" auf den einzelen Pixeln sitzt, während der andere Teil 62b, d. h. die Stromquelle 20, die Lastkapazität 22 und der Schalter 24 (Fig. 1), nur einmal vorhanden ist.

Vorzugsweise wird die Alternative verwendet, bei der die Schalter 12, die zur Unterbrechung des Gleichstromwegs durch den Transistor dienen, wenn der Schalter 24 geschlossen ist, um den Leistungsverbrauch gering zu halten. Dann können diese Schalter, die in Fig. 7 auch mit SEL1, SEL2, ..., SELN bezeichnet sind, gleichzeitig zum Multiplexen verwendet werden, was durch das Bezugszeichen 60 angedeutet werden soll. Wird das Pixel mit der Nummer 1 ausgelesen, so wird während des Auslesens der Schalter SEL1 geschlossen sein, während die anderen SELn-Schalter und der Schalter 24 geöffnet sind. Dann wird auch der Schalter SEL1 geöffnet, um in einem nicht-informationstragenden Teil den Schalter 24 zu schließen, um den erfindungsgemäßen Effekt des Rücksetzens auf ein Referenzpotential zu erreichen. Daran anschließend wird dann, um das zweite Pixel mit der Nr. 2 auszulesen, nur der Schalter SEL2 geschlossen usw. Damit erfüllen die Schalter 12 einerseits die Doppelfunktion des Multiplexens und andererseits des Unterbrechens des Gleichstromwegs durch die Transistoren, wenn der Schalter 24 geschlossen ist.

## Patentansprüche (Patentansprüche für folgende(n) Vertragsstaat(en): AT, BE, CH, CY, DK, ES, FI, GR, IE, LI, LU, MC, PT, SE)

1. Schaltung zum Verarbeiten eines Analogsignals, das eine zeitliche Folge von diskreten Signalpegeln aufweist, wobei jeder diskrete Signalpegel in einem zeitlichen Intervall (30 - 36) liegt und einen informationstragenden Abschnitt des Intervalls darstellt, während der Rest (38) des Intervalls ein nicht-informationstragender Abschnitt ist, mit folgenden Merkmalen:
einem Transistor (10; 10'; 10''; 10''') mit einem ersten (10a; 10a'; 10a''; 10a'''), einem zweiten (10b; 10b'; 10b''; 10b''') und einem dritten Anschluß (10c; 10c'; 10c''; 10c'''), wobei der Transistor derart angeordnet ist, daß durch ein Signal an dem ersten Anschluß ein Stromfluß zwischen dem zweiten und dem dritten Anschluß steuerbar ist, daß das zeitdiskrete Analogsignal (Uₑ) an den ersten Anschluß anlegbar ist, und daß der dritte Anschluß mit einem Ausgangsknoten (19) der Schaltung koppelbar ist;
einer Einrichtung (14) zum Anlegen einer Spannung zwischen einem ersten Knoten (16; 16') mit einem ersten Potential (D_{B}; 0V) und einem zweiten Knoten (18; 18') mit einem zweiten Potential (0 V; U_{B}), wobei der erste Knoten (16) mit dem zweiten Anschluß des Transistors koppelbar ist;
einer Einrichtung (20; 20') zum Liefern eines Gleichstroms (I_{DC}) zwischen zwei Anschlüssen, wobei ein Anschluß mit dem Ausgangsknoten (19) und der andere Anschluß mit dem zweiten Knoten (18; 18') verbunden ist;
einem ersten Schalter (24), der normalerweise geöffnet ist, und der steuerbar ist (Φ₁), um in einem geschlossenen Zustand den Ausgangsknoten (19) zumindest einen Teil des nicht-informationstragenden Abschnitts (38) des Intervalls (30, 32, 34, 36) mit einem Referenzknoten (26; 26') zu verbinden, um ein Referenzpotential am Ausgangsknoten (19) der Schaltung zu erzeugen; und
einem zweiten Schalter (12), der zwischen den zweiten Anschluß des Transistors (10; 10'; 10''; 10''') und den ersten Knoten (16; 16') geschaltet ist, und der steuerbar ist, um eine elektrisch leitfähige Verbindung zwischen dem ersten Knoten (16; 16') und dem zweiten AnSchluß (10b; 10b'; 10b''; 10b''') des Transistors (10; 10'; 10''; 10''') zumindest solange zu unterbrechen, wie der erste Schalter (24) den dritten Anschluß (10c; 10c'; 10c''; 10c''') des Transistors mit dem Referenzknoten (26; 26') verbindet.

2. Schaltung zum Verarbeiten eines Analogsignals, das eine zeitliche Folge von diskreten Signalpegeln aufweist, wobei jeder diskrete Signalpegel in einem zeitlichen Intervall (30 - 36) liegt und einen informationstragenden Abschnitt des Intervalls darstellt, während der Rest (38) des Intervalls ein nicht-informationstragender Abschnitt ist, mit folgenden Merkmalen:
einem Transistor (10; 10'; 10''; 10''') mit einem ersten (10a; 10a'; 10a''; 10a'''), einem zweiten (10b; 10b'; 10b''; 10b''') und einem dritten Anschluß (10c; 10c'; 10c''; 10c'''), wobei der Transistor derart angeordnet ist, daß durch ein Signal an dem ersten Anschluß ein Stromfluß zwischen dem zweiten und dem dritten Anschluß steuerbar ist, daß das zeitdiskrete Analogsignal (Uₑ) an den ersten Anschluß anlegbar ist, und daß der dritte Anschluß mit einem Ausgangsknoten (19) der Schaltung koppelbar ist;
einer Einrichtung (14) zum Anlegen einer Spannung zwischen einem ersten Knoten (16; 16') mit einem ersten Potential (U_{B}; 0V) und einem zweiten Knoten (18; 18') mit einem zweiten Potential (0 V; U_{B}), wobei der erste Knoten (16) mit dem zweiten Anschluß des Transistors koppelbar ist;
einer Einrichtung (20; 20') zum Liefern eines Gleichstroms (I_{DC}) zwischen zwei Anschlüssen, wobei ein Anschluß mit dem Ausgangsknoten (19) und der andere Anschluß mit dem zweiten Knoten (18; 18') verbunden ist;
einem ersten Schalter (24), der normalerweise geöffnet ist, und der steuerbar ist (Φ₁), um in einem geschlossenen Zustand den Ausgangsknoten (19) zumindest einen Teil des nicht-informationstragenden Abschnitts (38) des Intervalls (30, 32, 34, 36) mit einem Referenzknoten (26; 26') zu verbinden, um ein Referenzpotential am Ausgangsknoten (19) der Schaltung zu erzeugen; und
einem zweiten Schalter (12), der zwischen den dritten Anschluß (10c; 10c'; 10c''; 10c''') des Transistors und den Ausgangsknoten (19) der Schaltung geschaltet ist,
wobei der zweite Schalter (12) steuerbar ist, um eine elektrisch leitfähige Verbindung zwischen dem Ausgangsknoten (19) und dem dritten Anschluß des Transistors zumindest solange zu unterbrechen, wie der erste Schalter (24) den Ausgangsknoten mit dem zweiten Knoten verbindet.

3. Schaltung nach einem der vorhergehenden Ansprüche, bei der der Referenzknoten (26; 26') mit dem zweiten Knoten (18; 18') elektrisch leitfähig verbunden ist, derart, daß das Potential an dem Referenzknoten (26; 26') gleich dem Potential (0 V; U_{B}) an dem zweiten Knoten (18; 18') ist.

4. Schaltung nach Anspruch 1 oder 2, bei der der Referenzknoten (26; 26') ein Anschluß eines Kondensators ist, der aufgeladen ist, um das Referenzpotential zu erzeugen.

5. Schaltung nach Anspruch 1 oder 2, bei der der Referenzknoten (26; 26') ein Anschluß einer Spannungsversorgung ist, die sich von einer Spannungsversorgung unterscheidet, die mit der Einrichtung (14) zum Anlegen einer Spannung verbindbar ist.

6. Schaltung nach einem der vorhergehenden Ansprüche, bei der die Intervalle des Analogsignals (30, 32, 34, 36) eine konstante Länge aufweisen, die eine Taktfrequenz (f_{CLK}) eines Taktsignals definiert, und bei der der erste Schalter durch ein Steuert (Φ₁) steuerbar ist, das von dem Taktsignal abgeleitet ist.

7. Schaltung nach einem der vorhergehenden Ansprüche, bei der die Einrichtung (20; 20') zum Liefern eines Gleichstroms (I_{DC}) eine Konstantstromquelle mit hohem Innenwiderstand oder ein hochohmiger ohmscher Widerstand ist..

8. Schaltung nach einem der vorhergehenden Ansprüche,
bei der der Transistor (10) ein npn-Transistor ist, wobei der erste Anschluß (10a) ein Basisanschluß ist, der zweite Anschluß (10b) ein Kollektoranschluß ist und der dritte Anschluß (10c) ein Emitteranschluß ist, und
bei der die Einrichtung (14) zum Anlegen einer Spannung angeordnet ist, um an dem ersten Knoten (16) ein positives Potential (U_{B}) und an dem zweiten Knoten (18) ein Massepotential (0 V) zu erzeugen.

9. Schaltung nach einem der Ansprüche 1 bis 8,
bei der der Transistor (10') ein n-Kanal-FET ist, wobei der erste Anschluß (10a') ein Gate-Anschluß des Transistors ist, der zweite Anschluß (10b') ein Drain-Anschluß des Transistors ist und der dritte Anschluß (10c') ein Source-Anschluß des Transistors ist, und
bei der die Einrichtung (14) zum Anlegen einer Spannung angeordnet ist, um an dem ersten Knoten (16) ein positives Potential (U_{B}) und an dem zweiten Knoten (18) ein Massepotential (0 V) zu erzeugen.

10. Schaltung nach Anspruch 8 oder 9, bei der der erste Schalter (24) angeordnet ist, um zumindest so lange geschlossen zu sein, bis das Potential an dem Ausgangsknoten (19) kleiner oder gleich einem kleinsten zu erwartenden diskreten Signalpegel des Analogsignals ist.

11. Schaltung nach Anspruch 8 oder 9,
bei der das Potential an dem Referenzknoten (26) kleiner oder gleich dem niedrigsten zu erwartenden diskreten Signalpegel des Analogsignals ist, und
bei der der Schalter (24) angeordnet ist, um solange geschlossen zu sein, bis das Potential an dem Ausgangsknoten als Referenzpotential das Potential des Referenzknotens (26) hat.

12. Schaltung nach einem der Ansprüche 1 bis 7,
bei der der Transistor ein pnp-Transistor (10'') ist, wobei der erste Anschluß (10a'') eine Basis des Transistors ist, der zweite Anschluß (10b'') ein Kollektor des Transistors ist und der dritte Anschluß (10c'') ein Emitter des Transistors ist, und
bei der die Einrichtung (14) zum Anlegen einer Spannung angeordnet ist, um an dem ersten Knoten (16') ein Massepotential (0 V) und an dem zweiten Knoten (18') ein positives Spannungsversorgungspotential (U_{B}) zu erzeugen.

13. Schaltung nach einem der Ansprüche 1 bis 7,
bei der der Transistor ein p-Kanal-FET (10''') ist, wobei der erste Anschluß (10a''') ein Gate-Anschluß des Transistors ist, der zweite Anschluß (10b''') ein Drain-Anschluß des Transistors ist und der dritte Anschluß (10c''') ein Source-Anschluß des Transistors ist, und
bei der die Einrichtung (14) zum Anlegen einer Spannung angeordnet ist, um an dem ersten Knoten (16') ein Massepotential (0 V) und an dem zweiten Knoten (18') ein positives Spannungsversorgungspotential (U_{B}) zu erzeugen.

14. Schaltung nach Anspruch 12 oder 13, bei der der erste Schalter (24) angeordnet ist, um zumindest solange geschlossen zu sein, bis das Potential an dem Ausgangsknoten (19) größer oder gleich dem größten zu erwartenden diskreten Signalpegel ist.

15. Schaltung nach Anspruch 12 oder 13,
bei der ein an den Referenzknoten (26') anlegbares Signal größer oder gleich dem größten zu erwartenden diskreten Signalpegel des Analogsignals ist, und
bei der der erste Schalter (24) angeordnet ist, um solange geschlossen zu sein, bis das Referenzpotential an dem Ausgangsknoten (19) der Schaltung das erwünschte Potential ist.

16. Schaltung nach einem der vorhergehenden Ansprüche, die ferner eine Kapazität (C_{L}) zwischen dem Ausgangsknoten (19) der Schaltung und dem zweiten Knoten aufweist.

17. Bildsensor mit einer Mehrzahl von Pixelelementen (P1 bis P5), mit folgenden Merkmalen:
einer Einrichtung (60) zum seriellen Auslesen der Mehrzahl von Pixelelementen (P1 bis P5), um ein Analogsignal (Uₑ) zu liefern, das eine zeitliche Folge von diskreten Signalpegeln aufweist;
einer Schaltung (62) zum Verarbeiten des Analogsignals nach einem der Ansprüche 1 bis 15, um ein Ausgangssignal (Uₐ) zu liefern, das dem Eingangssignal (Uₑ) entspricht; und
einer Kapazität (64), die parallel zu einem Ausgang der Schaltung (62) angeordnet ist.

18. Bildsensor, mit folgenden Merkmalen:
einer Mehrzahl von Pixelelementen (P1 bis PN) wobei jedes Pixelelement folgende Merkmale aufweist:
einen Transistor (10; 10'; 10''; 10''') mit einem ersten (10a; 10a'; 10a''; 10a'''), einem zweiten (10b; 10b'; 10b''; 10b''') und einem dritten Anschluß (10c; 10c'; 10c''; 10c'''), wobei der Transistor derart angeordnet ist, daß durch ein Signal an dem ersten Anschluß ein Stromfluß zwischen dem zweiten und dem dritten Anschluß steuerbar ist, daß ein Pixelsignal (Uₑ₁, Uₑ₂, ..., U_{eN}) an den ersten Anschluß anlegbar ist, und daß der dritte Anschluß mit einem Ausgangsknoten (19) des Bildsensors koppelbar ist;
eine Einrichtung (14) zum Anlegen einer Spannung zwischen einem ersten Knoten (16; 16') mit einem ersten Potential (U_{B}; 0V) und einem zweiten Knoten (18; 18') mit einem zweiten Potential (0 V; U_{B}), wobei der erste Knoten (16) mit dem zweiten Anschluß des Transistors koppelbar ist; und
einen zweiten Schalter (SEL1, SEL2, ..., SELN) mit einem ersten und einem zweiten Anschluß, wobei der erste Anschluß des zweiten Schalters mit dem dritten Anschluß (10c; 10c'; 10c''; 10c''') des Transistors verbunden ist, und wobei der zweite Schalter (12) steuerbar ist, um seinen zweiten Anschluß mit dem dritten Anschluß des Transistors zu koppeln;
einer gemeinsamen Ausgangsleitung für die Mehrzahl von Pixelelementen, die mit dem Ausgangsknoten (19) des Bildsensors und den zweiten Anschlüssen der zweiten Schalter (SEL1, SEL2, ..., SELN) der Pixelelemente verbunden ist;
einer Einrichtung (20; 20') zum Liefern eines Gleichstroms (I_{DC}) zwischen zwei Anschlüssen, wobei ein Anschluß mit der Ausgangsleitung und der andere Anschluß mit dem zweiten Knoten (18; 18') verbunden ist;
einem ersten Schalter (24), der normalerweise geöffnet ist, und der steuerbar ist (Φ₁), um in einem geschlossenen Zustand die gemeinsame Ausgangsleitung zumindest einen Teil eines nicht-informationstragenden Abschnitts (38) eines Pixelsignals (Uₑ₁, Uₑ₂, ..., U_{eN}) mit einem Referenzknoten (26; 26') zu verbinden, um ein Referenzpotential am Ausgangsknoten (19) des Bildsensors zu erzeugen; und
einer Einrichtung (60) zum seriellen Auslesen der Mehrzahl von Pixelementen durch Steuern der zweiten Schalter (SEL1, SEL2, SELN), die angeordnet ist, um zum Liefern des Pixelsignals (Uₑ₁) eines Pixelelements (SEL1) zum Ausgangsknoten (19) nur den zweiten Schalter (SEL1) dieses Pixelelements (PIXEL 1) zu schließen, während die zweiten Schalter (SEL2, ..., SELN) der anderen Pixelelemente (PIXEL 2, ..., PIXEL N) offen sind.

## Patentansprüche (Patentansprüche für folgende(n) Vertragsstaat(en): DE, FR, GB, IT, NL)

1. Schaltung zum Verarbeiten eines Analogsignals, das eine zeitliche Folge von diskreten Signalpegeln aufweist, wobei jeder diskrete Signalpegel in einem zeitlichen Intervall (30 - 36) liegt und einen informationstragenden Abschnitt des Intervalls darstellt, während der Rest (38) des Intervalls ein nicht-informationstragender Abschnitt ist, mit folgenden Merkmalen:
einem Transistor (10; 10'; 10''; 10''') mit einem ersten (10a; 10a'; 10a''; 10a'''), einem zweiten (10b; 10b'; 10b''; 10b''') und einem dritten Anschluß (10c; 10c'; 10c''; 10c'''), wobei der Transistor derart angeordnet ist, daß durch ein Signal an dem ersten Anschluß ein Stromfluß zwischen dem zweiten und dem dritten Anschluß steuerbar ist, daß das zeitdiskrete Analogsignal (Uₑ) an den ersten Anschluß anlegbar ist, und daß der dritte Anschluß mit einem Ausgangsknoten (19) der Schaltung koppelbar ist;
einer Einrichtung (14) zum Anlegen einer Spannung zwischen einem ersten Knoten (16; 16') mit einem ersten Potential (U_{B}; 0V) und einem zweiten Knoten (18; 18') mit einem zweiten Potential (0 V; U_{B}), wobei der erste Knoten (16) mit dem zweiten Anschluß des Transistors koppelbar ist;
einer Einrichtung (20; 20') zum Liefern eines Gleichstroms (I_{DC}) zwischen zwei Anschlüssen, wobei ein Anschluß mit dem Ausgangsknoten (19) und der andere Anschluß mit dem zweiten Knoten (18; 18') verbunden ist;
einem ersten Schalter (24), der normalerweise geöffnet ist, und der steuerbar ist (Φ₁), um in einem geschlossenen Zustand den Ausgangsknoten (19) zumindest einen Teil des nicht-informationstragenden Abschnitts (38) des Intervalls (30, 32, 34, 36) mit einem Referenzknoten (26; 26') zu verbinden, um ein Referenzpotential am Ausgangsknoten (19) der Schaltung zu erzeugen; und
einem zweiten Schalter (12), der zwischen den zweiten Anschluß des Transistors (10; 10'; 10''; 10''') und den ersten Knoten (16; 16') geschaltet ist, und der steuerbar ist, um eine elektrisch leitfähige Verbindung zwischen dem ersten Knoten (16; 16') und dem zweiten Anschluß (10b; 10b'; 10b''; 10b''') des Transistors (10; 10'; 10''; 10''') zumindest solange zu unterbrechen, wie der erste Schalter (24) den dritten Anschluß (10c; 10c'; 10c''; 10c''') des Transistors mit dem Referenz knoten (26; 26') verbindet,
wobei die Schaltung ferner eine Lastkapazität (C_{L}) zwischen dem Ausgangsknoten (19) und dem zweiten Knoten aufweist, so daß ein Ladezustand der Lastkapazität (C_{L}) durch Schließen des ersten Schalters (24) beeinflussbar ist.

2. Schaltung zum Verarbeiten eines Analogsignals, das eine zeitliche Folge von diskreten Signalpegeln aufweist, wobei jeder diskrete Signalpegel in einem zeitlichen Intervall (30 - 36) liegt und einen informationstragenden Abschnitt des Intervalls darstellt, während der Rest (38) des Intervalls ein nicht-informationstragender Abschnitt ist, mit folgenden Merkmalen:
einem Transistor (10; 10'; 10''; 10''') mit einem ersten (10a; 10a'; 10a''; 10a'''), einem zweiten (10b; 10b'; 10b''; 10b''') und einem dritten Anschluß (10c; 10c'; 10c''; 10c'''), wobei der Transistor derart angeordnet ist, daß durch ein Signal an dem ersten Anschluß ein Stromfluß zwischen dem zweiten und dem dritten Anschluß steuerbar ist, daß das zeitdiskrete Analogsignal (Uₑ) an den ersten Anschluß anlegbar ist, und daß der dritte Anschluß mit einem Ausgangsknoten (19) der Schaltung koppelbar ist;
einer Einrichtung (14) zum Anlegen einer Spannung zwischen einem ersten Knoten (16; 16') mit einem ersten Potential (U_{B}; 0V) und einem zweiten Knoten (18; 18') mit einem zweiten Potential (0 V; U_{B}), wobei der erste Knoten (16) mit dem zweiten Anschluß des Transistors koppelbar ist;
einer Einrichtung (20; 20') zum Liefern eines Gleichstroms (I_{DC}) zwischen zwei Anschlüssen, wobei ein Anschluß mit dem Ausgangsknoten (19) und der andere Anschluß mit dem zweiten Knoten (18; 18') verbunden ist;
einem ersten Schalter (24), der normalerweise geöffnet ist, und der steuerbar ist (Φ₁), um in einem geschlossenen Zustand den Ausgangsknoten (19) zumindest einen Teil des nicht-informationstragenden Abschnitts (38) des Intervalls (30, 32, 34, 36) mit einem Referenzknoten (26; 26') zu verbinden, um ein Referenzpotential am Ausgangsknoten (19) der Schaltung zu erzeugen; und
einem zweiten Schalter (12), der zwischen den dritten Anschluß (10c; 10c'; 10c''; 10c''') des Transistors und den Ausgangsknoten (19) der Schaltung geschaltet ist, wobei der zweite Schalter (12) steuerbar ist, um eine elektrisch leitfähige Verbindung zwischen dem Ausgangsknoten (19) und dem dritten Anschluß des Transistors zumindest solange zu
unterbrechen, wie der erste Schalter (24) den Ausgangsknoten mit dem zweiten Knoten verbindet
wobei die Schaltung ferner eine Lastkapazität (C_{L}) zwischen dem Ausgangsknoten (19) und dem zweiten Knoten aufweist, so daß ein Ladezustand der Lastkapazität (C_{L}) durch Schließen des ersten Schalters (24) beeinflussbar ist.

3. Schaltung nach einem der vorhergehenden Ansprüche, bei der der Referenzknoten (26; 26') mit dem zweiten Knoten (18; 18') elektrisch leitfähig verbunden ist, derart, daß das Potential an dem Referenzknoten (26; 26') gleich dem Potential (0 V; U_{B}) an dem zweiten Knoten (18; 18') ist.

4. Schaltung nach Anspruch 1 oder 2, bei der der Referenzknoten (26; 26') ein Anschluß eines Kondensators ist, der aufgeladen ist, um das Referenzpotential zu erzeugen.

5. Schaltung nach Anspruch 1 oder 2, bei der der Referenzknoten (26; 26') ein Anschluß einer Spannungsversorgung ist, die sich von einer Spannungsversorgung unterscheidet, die mit der Einrichtung (14) zum Anlegen einer Spannung verbindbar ist.

6. Schaltung nach einem der vorhergehenden Ansprüche, bei der die Intervalle des Analogsignals (30, 32, 34, 36) eine konstante Länge aufweisen, die eine Taktfrequenz (f_{CLK}) eines Taktsignals definiert, und bei der der erste Schalter durch ein Steuersignal (Φ₁) steuerbar ist, das von dem Taktsignal abgeleitet ist.

7. Schaltung nach einem der vorhergehenden Ansprüche, bei der die Einrichtung (20; 20') zum Liefern eines Gleichstroms (I_{DC}) eine Konstantstromquelle mit hohem Innenwiderstand oder ein hochohmiger ohmscher Widerstand ist.

8. Schaltung nach einem der vorhergehenden Ansprüche,
bei der der Transistor (10) ein npn-Transistor ist, wobei der erste Anschluß (10a) ein Basisanschluß ist, der zweite Anschluß (10b) ein Kollektoranschluß ist und der dritte Anschluß (10c) ein Emitteranschluß ist, und
bei der die Einrichtung (14) zum Anlegen einer Spannung angeordnet ist, um an dem ersten Knoten (16) ein positives Potential (U_{B}) und an dem zweiten Knoten (18) ein Massepotential (0 V) zu erzeugen.

9. Schaltung nach einem der Ansprüche 1 bis 8,
bei der der Transistor (10') ein n-Kanal-FET ist, wobei der erste Anschluß (10a') ein Gate-Anschluß des Transistors ist, der zweite Anschluß (10b') ein Drain-Anschluß des Transistors ist und der dritte Anschluß (10c') ein Source-Anschluß des Transistors ist, und
bei der die Einrichtung (14) zum Anlegen einer Spannung angeordnet ist, um an dem ersten Knoten (16) ein positives Potential (U_{B}) und an dem zweiten Knoten (18) ein Massepotential (0 V) zu erzeugen.

10. Schaltung nach Anspruch 8 oder 9, bei der der erste Schalter (24) angeordnet ist, um zumindest so lange geschlossen zu sein, bis das Potential an dem Ausgangsknoten (19) kleiner oder gleich einem kleinsten zu erwartenden diskreten Signalpegel des Analogsignals ist.

11. Schaltung nach Anspruch 8 oder 9,
bei der das Potential an dem Referenzknoten (26) kleiner oder gleich dem niedrigsten zu erwartenden diskreten Signalpegel des Analogsignals ist, und
bei der der Schalter (24) angeordnet ist, um solange geschlossen zu sein, bis das Potential an dem Ausgangsknoten als Referenzpotential das Potential des Referenzknotens (26) hat.

12. Schaltung nach einem der Ansprüche 1 bis 7,
bei der der Transistor ein pnp-Transistor (10'') ist, wobei der erste Anschluß (10a'') eine Basis des Transistors ist, der zweite Anschluß (10b'') ein Kollektor des Transistors ist und der dritte Anschluß (10c'') ein Emitter des Transistors ist, und
bei der die Einrichtung (14) zum Anlegen einer Spannung angeordnet ist, um an dem ersten Knoten (16') ein Massepotential (0 V) und an dem zweiten Knoten (18') ein positives Spannungsversorgungspotential (U_{B}) zu erzeugen.

13. Schaltung nach einem der Ansprüche 1 bis 7,
bei der der Transistor ein p-Kanal-FET (10''') ist, wobei der erste Anschluß (10a''') ein Gate-Anschluß des Transistors ist, der zweite Anschluß (10b''') ein Drain-Anschluß des Transistors ist und der dritte Anschluß (10c''') ein Source-Anschluß des Transistors ist, und
bei der die Einrichtung (14) zum Anlegen einer Spannung angeordnet ist, um an dem ersten Knoten (16') ein Massepotential (0 V) und an dem zweiten Knoten (18') ein positives Spannungsversorgungspotential (U_{B}) zu erzeugen.

14. Schaltung nach Anspruch 12 oder 13, bei der der erste Schalter (24) angeordnet ist, um zumindest solange geschlossen zu sein, bis das Potential an dem Ausgangs knoten (19) größer oder gleich dem größten zu erwartenden diskreten Signalpegel ist.

15. Schaltung nach Anspruch 12 oder 13,
bei der ein an den Referenzknoten (26') anlegbares Signal größer oder gleich dem größten zu erwartenden diskreten Signalpegel des Analogsignals ist, und
bei der der erste Schalter (24) angeordnet ist, um solange geschlossen zu sein, bis das Referenzpotential an dem Ausgangsknoten (19) der Schaltung das erwünschte Potential ist.

16. Bildsensor mit einer Mehrzahl von Pixelelementen (P1 bis P5), mit folgenden Merkmalen:
einer Einrichtung (60) zum seriellen Auslesen der Mehrzahl von Pixelelementen (P1 bis P5), um ein Analogsignal (Uₑ) zu liefern, das eine zeitliche Folge von diskreten Signalpegeln aufweist;
einer Schaltung (62) zum Verarbeiten des Analogsignals nach einem der Ansprüche 1 bis 15, um ein Ausgangssignal (Uₐ) zu liefern, das dem Eingangssignal (Uₑ) entspricht; und
einer Lastkapazität (64), die zwischen einen Ausgang der Schaltung (62) und einen zweiten Knoten der Schaltung geschaltet ist, so daß ein Ladezustand der Lastkapazität (C_{L}) durch Schließen eines ersten Schalters (24) der Schaltung zum Verarbeiten beeinflussbar ist.

17. Bildsensor, mit folgenden Merkmalen:
einer Mehrzahl von Pixelelementen (P1 bis PN) wobei jedes Pixelelement folgende Merkmale aufweist:
einen Transistor (10; 10'; 10''; 10''') mit einem ersten (10a; 10a'; 10a''; 10a'''), einem zweiten (10b; 10b'; 10b''; 10b''') und einem dritten Anschluß (10c; 10c'; 10c''; 10c'''), wobei der Transistor derart angeordnet ist, daß durch ein Signal an dem ersten Anschluß ein Stromfluß zwischen dem zweiten und dem dritten Anschluß steuerbar ist, daß ein Pixelsignal (Uₑ₁, Uₑ₂, ..., U_{eN}) an den ersten Anschluß anlegbar ist, und daß der dritte Anschluß mit einem Ausgangsknoten (19) des Bildsensors koppelbar ist;
eine Einrichtung (14) zum Anlegen einer Spannung zwischen einem ersten Knoten (16; 16') mit einem ersten Potential (U_{B}; 0V) und einem zweiten Knoten (18; 18') mit einem zweiten Potential (0 V; U_{B}), wobei der erste Knoten (16) mit dem zweiten Anschluß des Transistors koppelbar ist; und
einen zweiten Schalter (SEL1, SEL2, ..., SELN) mit einem ersten und einem zweiten Anschluß, wobei der erste Anschluß des zweiten Schalters mit dem dritten Anschluß (10c; 10c'; 10c''; 10c''') des Transistors verbunden ist, und wobei der zweite Schalter (12) steuerbar ist, um seinen zweiten Anschluß mit dem dritten Anschluß des Transistors zu koppeln;
einer gemeinsamen Ausgangsleitung für die Mehrzahl von Pixelelementen, die mit dem Ausgangsknoten (19) des Bildsensors und den zweiten Anschlüssen der zweiten Schalter (SEL1, SEL2, ..., SELN) der Pixelelemente verbunden ist;
einer Einrichtung (20; 20') zum Liefern eines Gleichstroms (I_{DC}) zwischen zwei Anschlüssen, wobei ein Anschluß mit der Ausgangsleitung und der andere Anschluß mit dem zweiten Knoten (18; 18') verbunden ist;
einem ersten Schalter (24), der normalerweise geöffnet ist, und der steuerbar ist (Φ₁), um in einem geschlossenen Zustand die gemeinsame Ausgangsleitung zumindest einen Teil eines nicht-informationstragenden Abschnitts (38) eines Pixelsignals (Uₑ₁, Uₑ₂, ..., U_{eN}) mit einem Referenzknoten (26; 26') zu verbinden, um ein Referenzpotential am Ausgangsknoten (19) des Bildsensors zu erzeugen; und
einer Einrichtung (60) zum seriellen Auslesen der Mehrzahl von Pixelementen durch Steuern der zweiten Schalter (SEL1, SEL2, SELN), die angeordnet ist, um zum Liefern des Pixelsignals (Uₑ₁) eines Pixelelements (SEL1) zum Ausgangsknoten (19) nur den zweiten Schalter (SEL1) dieses Pixelelements (PIXEL 1) zu schließen, während die zweiten Schalter (SEL2, ..., SELN) der anderen Pixelelemente (PIXEL 2, ..., PIXEL N) offen sind,
wobei ferner eine Lastkapazität (C_{L}) zwischen dem Ausgangsknoten (19) und dem zweiten Knoten geschaltet ist, so daß ein Ladezustand der Lastkapazität (C_{L}) durch Schließen des ersten Schalters (24) beeinflussbar ist.

## Claims (Claims for the following Contracting State(s): AT, BE, CH, CY, DK, ES, FI, GR, IE, LI, LU, MC, PT)

1. Circuit for processing an analog signal comprising a time sequence of discrete signal levels, with each discrete signal level lying in a time interval (30 - 36) and representing an information-carrying section of the interval, while the remainder (38) of the interval is a non-information carrying section, the circuit comprising:
a transistor (10; 10';10'';10''') with a first (10a; 10a'; 10a''; 10a'''), a second (10b; 10b'; 10b''; 10b'''), and a third terminal (10c; 10c'; 10c''; 10c'''), with the transistor being arranged such that by means of a signal at the first terminal a current flow between the second and the third terminal is controllable, that the time-discrete analog signal (Uₑ) is adapted to be applied the first terminal, and that the third terminal is adapted to be coupled to an output node (19) of the circuit;
a means (14) for applying a voltage between a first node (16; 16') with a first potential (U_{B}; OV) and a second node (18; 18') with a second potential (O V; U_{B}), with the first node (16) being adapted to be coupled to the second terminal of the transistor;
a means (20; 20') for delivering a direct current (I_{DC}) between two terminals, with one terminal being connected to the output node (19) and the other terminal being connected to the second node (18; 18');
a first switch (24), which is normally opened and which is controllable (Φ₁) in order to connect, in a closed state, the output node (19), during at least a part of the non-information carrying section (38) of the interval (30, 32, 34, 36), to a reference node (26; 26') to generate a reference potential at the output node (19) of the circuit; and
a second switch (12), which is connected between the second terminal of the transistor (10; 10'; 10''; 10''') and the first node (16; 16') and which is controllable to interrupt an electrically conductive connection between the first node (16; 16') and the second terminal (10b; 10b'; 10b''; 10b''') of the transistor (10; 10'; 10''; 10''') for at least as long as the first switch (24) connects the third terminal (10c; 10c'; 10c''; 10c''') of the transistor to the reference node (26; 26').

2. Circuit for processing an analog signal comprising a time sequence of discrete signal levels, with each discrete signal level lying in a time interval (30 - 36) and representing an information-carrying section of the interval, while the remainder (38) of the interval is a non-information carrying section, comprising:
a transistor (10; 10'; 10''; 10''') with a first (10a; 10a'; 10a''; 10a'''), a second (10b; 10b'; 10b''; 10b''') and a third terminal (10c; 10c'; 10c''; 10c'''), with the transistor being arranged such that by means a signal at the first terminal a current flow between the second and the third terminal is controllable, that the time-discrete analog signal (Uₑ) is adapted to be applied to the first terminal, and that the third terminal is adapted to be coupled to an output node (19) of the circuit;
a means (14) for applying a voltage between a first node (16; 16') with a first potential (U_{B}; OV) and a second node (18; 18') with a second potential (0 V; U_{B}), with the first node (16) being adapted to be coupled to the second terminal of the transistor;
a means (20; 20') for delivering a direct current (I_{DC}) between two terminals, with one terminal being connected to the output node (19) and the other terminal being connected to the second node (18; 18');
a first switch (24), which is normally opened and which is controllable (Φ₁), to connect, in a closed state, the output node (19) during at least a part of the non-information carrying section (38) of the interval (30, 32, 34, 36), to a reference node (26; 26') to generate a reference potential at the output node (19) of the circuit; and
a second switch (12), which is connected between the third terminal (10c; 10c'; 10c''; 10c''') of the transistor and the output node (19) of the circuit, with the second switch (12) being controllable to interrupt an electrically conductive connection between the output node (19) and the third terminal of the transistor for at least as long as the first switch (24) connects the output node to the second node.

3. Circuit in accordance with one of the preceding claims, wherein the reference node (26; 26') is conductively connected to the second node (18; 18') such that the potential at the reference node (26; 26') is equal to the potential (0 V; U_{B}) at the second node (18; 18').

4. Circuit in accordance with claim 1 or 2, wherein the reference node (26; 26') is a terminal of a capacitor charged to generate the reference potential.

5. Circuit in accordance with claim 1 or 2, wherein the reference node (26; 26') is a terminal of a voltage supply which differs from a voltage supply which is connectable to the means (14) for applying a voltage.

6. Circuit in accordance with one of the preceding claims, wherein the intervals of the analog signal (30, 32, 34, 36) comprise a constant length, which defines a clock frequency (f_{CLK}) of a clock signal, and wherein the first switch is controllable by a control signal (Φ₁) which is derived from the clock signal.

7. Circuit in accordance with one of the preceding claims, wherein the means (20; 20') for delivering a direct current (I_{DC}) is a constant current source with a high internal resistance or a high-ohmic ohmic resistor.

8. Circuit in accordance with one of the preceding claims,
wherein the transistor (10) is an npn-transistor, with the first terminal (10a) being a base terminal, the second terminal (10b) being a collector terminal, and the third terminal (10c) being an emitter terminal, and
wherein the means (14) for applying a voltage is arranged to generate at the first node (16) a positive potential (U_{B}) and at the second node (18) a mass potential (0 V).

9. Circuit in accordance with one of claims 1 to 7,
wherein the transistor (10') is an n-channel-FET, with the first terminal (10a') being a gate terminal of the transistor, the second terminal (10b') being a drain terminal of the transistor, and the third terminal (10c') being a source terminal of the transistor, and
wherein the means (14) for applying a voltage is arranged to generate at the first node (16) a positive potential (U_{B}) and at the second node (18) a mass potential (0 V).

10. Circuit in accordance with claim 8 or 9, wherein the first switch (24) is arranged to be closed for at least as long until the potential at the output node (19) is less than or equal to a smallest discrete signal level of the analog signal to be expected.

11. Circuit in accordance with claim 8 or 9,
wherein the potential at the reference node (26) is less than or equal to the smallest discrete signal level of the analog signal to be expected, and
wherein the switch (24) is arranged to be closed until the potential at the output node has the potential of the reference node (26) as a reference potential.

12. Circuit in accordance with one of claims 1 to 7,
wherein the transistor is a pnp-transistor (10''), with the first terminal (10a'') being a base of the transistor, the second terminal (10b'') being a collector of the transistor, and the third terminal (10c'') being an emitter of the transistor, and
wherein the means (14) for applying a voltage is arranged to generate at the first node (16') a mass potential (0 V) and at the second node (18') a positive voltage supply potential (U_{B}).

13. Circuit in accordance with one of claims 1 to 7,
wherein the transistor is a p-channel FET (10'''), with the first terminal (10a''') being a gate terminal of the transistor, the second terminal (10b''') being a drain terminal of the transistor, and the third terminal (10c''') being a source terminal of the transistor, and
wherein the means (14) for applying a voltage is arranged to generate at the first node (16') a mass potential (0 V) and at the second node (18') a positive voltage supply potential (U_{B}).

14. Circuit in accordance with claim 12 or 13,
wherein the first circuit (24) is arranged to be closed for at least as long until the potential at the output node (19) is greater than or equal to the greatest discrete signal level to be expected.

15. Circuit in accordance with claim 12 or 13,
wherein a signal which may be applied to the reference node (26') is greater than or equal to the greatest discrete signal level of the analog signal to be expected, and
wherein the first switch (24) is arranged to be closed until the reference potential at the output node (19) of the circuit is the desired potential.

16. Circuit in accordance with one of the preceding claims, further comprising a capacity (C_{L}) between the output node (19) of the circuit and the second node.

17. Image sensor with a plurality of pixel elements (P1 to P5), comprising:
a means (60) for serially reading out the plurality of pixel elements (P1 to P5) to deliver an analog signal (Uₑ) comprising a time sequence of discrete signal levels;
a circuit (62) for processing the analog signal in accordance with one of claims 1 to 15 to deliver an output signal (Uₐ) corresponding to the input signal (Uₑ); and
a capacitance (64) arranged in parallel to an output of the circuit (62).

18. Image sensor, comprising:
a plurality of pixel elements (P1 to PN), with each pixel element comprising:
a transistor (10; 10'; 10''; 10''') with a first (10a; 10a'; 10a''; 10a'''), a second (10b; 10b'; 10b''; 10b'''), and a third terminal (10c; 10c'; 10c''; 10c'''), with the transistor being arranged such that by means of a signal at the first terminal a current flow between the second and third terminal is controllable, that a pixel signal (Uₑ₁, Uₑ₂, ..., U_{eN}) is adapted to be applied to the first terminal, and that the third terminal is adapted to be coupled to an output node (19) of the image sensor;
a means (14) for applying a voltage between a first node (16; 16') with a first potential (U_{B}; OV) and a second node (18; 18') with a second potential (0 V; U_{B}), with the first node (16) being adapted to be coupled to the second terminal of the transistor; and
a second switch (SEL1, SEL2,..., SELN) with a first and a second terminal, with the first terminal of the second switch being connected to the third terminal (10c; 10c'; 10c''; 10c''') of the transistor, and with the second switch (12) being controllable to couple its second terminal to the third terminal of the transistor;
a common output line for the plurality of pixel elements connected to the output node (19) of the image sensor and the second terminals of the second switches (SEL1, SEL2,..., SELN) of the pixel elements;
a means (20; 20') for providing a direct current (I_{DC}) between two terminals, with one terminal being connected to the output line and the other terminal being connected to the second node (18; 18') ;
a first switch (24), which is normally opened and which is controllable (Φ₁), to connect, in a closed state, the common output line during at least a part of a non-information carrying section (38) of a pixel signal (Uₑ₁, Uₑ₂, ..., U_{eN}), to a reference node (26; 26') to generate a reference potential at the output node (19) of the image sensor; and
a means (60) for serially reading out the plurality of pixel elements by controlling the second switches (SEL1, SEL2, SELN), which is arranged to close only the second switch (SEL1) of a pixel element (PIXEL 1) for providing the pixel signal (Uₑ₁) of this pixel element (SEL1) to the output node (19), while the second switches (SEL2), ..., SELN) of the other pixel elements (PIXEL 2, ..., PIXEL N) are open.

## Claims (Claims for the following Contracting State(s): DE, FR, GB, IT, NL)

1. Circuit for processing an analog signal comprising a time sequence of discrete signal levels, with each discrete signal level lying in a time interval (30 - 36) and representing an information-carrying section of the interval, while the remainder (38) of the interval is a non-information carrying section, the circuit comprising:
a transistor (10; 10';10'';10''') with a first (10a; 10a'; 10a''; 10a'''), a second (10b; 10b'; 10b''; 10b'''), and a third terminal (10c; 10c'; 10c''; 10c'''), with the transistor being arranged such that by means of a signal at the first terminal a current flow between the second and the third terminal is controllable, that the time-discrete analog signal (Uₑ) is adapted to be applied to the first terminal, and that the third terminal is adapted to be coupled to an output node (19) of the circuit;
a means (14) for applying a voltage between a first node (16; 16') with a first potential (U_{B}; OV) and a second node (18; 18') with a second potential (O V; U_{B}), with the first node (16) being adapted to be coupled to the second terminal of the transistor;
a means (20; 20') for delivering a direct current (I_{DC}) between two terminals, with one terminal being connected to the output node (19) and the other terminal being connected to the second node (18; 18');
a first switch (24), which is normally opened and which is controllable (Φ₁) in order to connect, in a closed state, the output node (19), during at least a part of the non-information carrying section (38) of the interval (30, 32, 34, 36), to a reference node (26; 26') to generate a reference potential at the output node (19) of the circuit; and
a second switch (12), which is connected between the second terminal of the transistor (10; 10'; 10''; 10''') and the first node (16; 16') and which is controllable to interrupt an electrically conductive connection between the first node (16; 16') and the second terminal (10b; 10b'; 10b''; 10b''') of the transistor (10; 10'; 10''; 10''') for at least as long as the first switch (24) connects the third terminal (10c; 10c'; 10c''; 10c''') of the transistor to the reference node (26; 26'),
the circuit further comprising a load capacitance (C_{L}) between the output node (19) and the second node such that a charging state of the load capacitance (C_{L}) may be influenced by closing the first switch (24).

2. Circuit for processing an analog signal comprising a time sequence of discrete signal levels, with each discrete signal level lying in a time interval (30 - 36) and representing an information-carrying section of the interval, while the remainder (38) of the interval is a non-information carrying section, comprising:
a transistor (10; 10'; 10''; 10''') with a first (10a; 10a'; 10a''; 10a'''), a second (10b; 10b'; 10b''; 10b'''), and a third terminal (10c; 10c'; 10c''; 10c'''), with the transistor being arranged such that by means of a signal at the first terminal a current flow between the second and the third terminal is controllable, that the time-discrete analog signal (Uₑ) is adapted to be applied to the first terminal, and that the third terminal is adapted to be coupled to an output node (19) of the circuit;
a means (14) for applying a voltage between a first node (16; 16') with a first potential (U_{B}; OV) and a second node (18; 18') with a second potential (0 V; U_{B}), with the first node (16) being adapted to be coupled to the second terminal of the transistor;
a means (20; 20') for delivering a direct current (I_{DC}) between two terminals, with one terminal being connected to the output node (19) and the other terminal being connected to the second node (18; 18');
a first switch (24), which is normally opened and which is controllable (Φ₁), to connect, in a closed state, the output node (19) during at least a part of the non-information carrying section (38) of the interval (30, 32, 34, 36), to a reference node (26; 26') to generate a reference potential at the output node (19) of the circuit; and
a second switch (12), which is connected between the third terminal (10c; 10c'; 10c''; 10c''') of the transistor and the output node (19) of the circuit, with the second switch (12) being controllable to interrupt an electrically conductive connection between the output node (19) and the third terminal of the transistor for at least as long as the first switch (24) connects the output node to the second node,
the circuit further comprising a load capacitance (C_{L}) between the output node (19) and the second node such that a load capacitance (C_{L}) may be influenced by closing the first switch (24).

3. Circuit in accordance with one of the preceding claims, wherein the reference node (26; 26') is conductively connected to the second node (18; 18') such that the potential at the reference node (26; 26') is equal to the potential (0 V; U_{B}) at the second node (18; 18').

4. Circuit in accordance with claim 1 or 2, wherein the reference node (26; 26') is a terminal of a capacitor charged to generate the reference potential.

5. Circuit in accordance with claim 1 or 2, wherein the reference node (26; 26') is a terminal of a voltage supply which differs from a voltage supply which is connectable to the means (14) for applying a voltage.

6. Circuit in accordance with one of the preceding claims, wherein the intervals of the analog signal (30, 32, 34, 36) comprise a constant length, which defines a clock frequency (f_{CLK}) of a clock signal, and wherein the first switch is controllable by a control signal (Φ₁) which is derived from the clock signal.

7. Circuit in accordance with one of the preceding claims, wherein the means (20; 20') for delivering a direct current (I_{DC}) is a constant current source with a high internal resistance or a high-ohmic ohmic resistor.

8. Circuit in accordance with one of the preceding claims,
wherein the transistor (10) is an npn-transistor, with the first terminal (10a) being a base terminal, the second terminal (10b) being a collector terminal, and the third terminal (10c) being an emitter terminal, and
wherein the means (14) for applying a voltage is arranged to generate at the first node (16) a positive potential (U_{B}) and at the second node (18) a mass potential (0 V).

9. Circuit in accordance with one of claims 1 to 7,
wherein the transistor (10') is an n-channel-FET, with the first terminal (10a') being a gate terminal of the transistor, the second terminal (10b') being a drain terminal of the transistor, and the third terminal (10c') being a source terminal of the transistor, and
wherein the means (14) for applying a voltage is arranged to generate at the first node (16) a positive potential (U_{B}) and at the second node (18) a mass potential (0 V).

10. Circuit in accordance with claim 8 or 9,
wherein the first switch (24) is arranged to be closed for at least as long until the potential at the output node (19) is less than or equal to a smallest discrete signal level of the analog signal to be expected.

11. Circuit in accordance with claim 8 or 9,
wherein the potential at the reference node (26) is less than or equal to the lowest discrete signal level of the analog signal to be expected, and
wherein the switch (24) is arranged to be closed until the potential at the output node has the potential of the reference node (26) as the reference potential.

12. Circuit in accordance with one of claims 1 to 7,
wherein the transistor is a pnp-transistor (10''), with the first terminal (10a'') being a base of the transistor, the second terminal (10b'') being a collector of the transistor, and the third terminal (10c'') being an emitter of the transistor, and
wherein the means (14) for applying a voltage is arranged to generate at the first node (16') a mass potential (0 V) and at the second node (18') a positive voltage supply potential (U_{B}).

13. Circuit in accordance with one of claims 1 to 7,
wherein the transistor is a p-channel FET (10'''), with the first terminal (10a''') being a gate terminal of the transistor, the second terminal (10b''') being a drain terminal of the transistor, and the third terminal (10c''') being a source terminal of the transistor, and
wherein the means (14) for applying a voltage is arranged to generate at the first node (16') a mass potential (0 V) and at the second node (18') a positive voltage supply potential (U_{B}).

14. Circuit in accordance with claim 12 or 13, wherein the first circuit (24) is arranged to be closed for at least as long until the potential at the output node (19) is greater than or equal to the greatest discrete signal level to be expected.

15. Circuit in accordance with claim 12 or 13,
wherein a signal which may be applied to the reference node (26') is greater than or equal to the greatest discrete signal level of the analog signal to be expected, and
wherein the first switch (24) is arranged to be closed until the reference potential at the output node (19) of the circuit is the desired potential.

16. Image sensor with a plurality of pixel elements (P1 to P5), comprising:
a means (60) for serially reading out the plurality of pixel elements (P1 to P5) to deliver an analog signal (Uₑ) comprising a time sequence of discrete signal levels;
a circuit (62) for processing the analog signal in accordance with one of claims 1 to 15 to deliver an output signal (Uₐ) corresponding to the input signal (Uₑ); and
a load capacitance (64) connected between an output of the circuit (62) and a second node of the circuit so that a charging state of the load capacitance (CL) may be influenced by closing a first switch (24) of the circuit for processing.

17. Image sensor, comprising:
a plurality of pixel elements (P1 to PN), with each pixel element comprising:
a transistor (10; 10'; 10''; 10''') with a first (10a; 10a'; 10a''; 10a'''), a second (10b; 10b'; 10b''; 10b'''), and a third terminal (10c; 10c'; 10c''; 10c'''), with the transistor being arranged such that by means of a signal at the first terminal a current flow between the second and third terminal is controllable, that a pixel signal (Uₑ₁, Uₑ₂, ..., U_{eN}) is adapted to be applied to the first terminal, and that the third terminal is adapted to be coupled to an output node (19) of the image sensor;
a means (14) for applying a voltage between a first node (16; 16') with a first potential (U_{B}; OV) and a second node (18; 18') with a second potential (0 V; U_{B}), with the first node (16) being adapted to be coupled to the second terminal of the transistor; and
a second switch (SEL1, SEL2,..., SELN) with a first and a second terminal, with the first terminal of the second switch being connected to the third terminal (10c; 10c'; 10c''; 10c''') of the transistor, and with the second switch (12) being controllable to couple its second terminal to the third terminal of the transistor;
a common output line for the plurality of pixel elements connected to the output node (19) of the image sensor and to the second terminals of the second switches (SEL1, SEL2,..., SELN) of the pixel elements;
a means (20; 20') for providing a direct current (I_{DC}) between two terminals, with one terminal being connected to the output line and the other terminal being connected to the second node (18; 18');
a first switch (24), which is normally opened and which is controllable (Φ₁), to connect, in a closed state, the common output line, during at least a part of a non-information carrying section (38) of a pixel signal (Uₑ₁, Uₑ₂, ..., U_{eN}), to a reference node (26; 26') to generate a reference potential at the output node (19) of the image sensor; and
a means (60) for serially reading out the plurality of pixel elements by controlling the second switches (SEL1, SEL2, SELN), which is arranged to close only the second switch (SEL1) of a pixel element (PIXEL 1) for providing the pixel signal (Uₑ₁) of a pixel element (SEL1) to the output node (19), while the second switches (SEL2), ..., SELN) of the other pixel elements (PIXEL 2, ..., PIXEL N) are open,
with a load capacitance further being connected between the output node (19) and the second node so that a charging state of the load capacitance (C_{L}) may be influenced by closing the first switch (24).

## Revendications (Revendications pour l'(les) Etat(s) contractant(s) suivant(s): AT, BE, CH, CY, DK, ES, FI, GR, IE, LI, LU, MC, PT, SE)

1. Circuit pour le traitement d'un signal analogique présentant une succession dans le temps de niveaux de signal discret, chaque niveau de signal discret étant situé dans un intervalle de temps (30 à 36) et représentant un segment portant des informations de l'intervalle, tandis que le reste (38) de l'intervalle est un segment ne portant pas d'informations, aux caractéristiques suivantes :
un transistor (10; 10'; 10''; 10"') avec une première (10a; 10a'; 10a''; 10a'''), une seconde (10b; 10b'; 10b''; 10b''') et une troisième connexion (10c; 10c'; 10c''; 10c'''), le transistor étant disposé de telle sorte que par un signal à la première connexion peut être réglé un flux de courant entre la seconde et la troisième connexion, que le signal analogique discret dans le temps (Uₑ) peut être appliqué à la première connexion et que la troisième connexion peut être couplée à un noeud de sortie (19) du circuit ;
un dispositif (14) destiné à appliquer une tension entre un premier noeud (16 ; 16') avec un premier potentiel (U_{B} ; 0V) et un second noeud (18 ; 18') avec un second potentiel (0V ; U_{B}), le premier noeud (16) pouvant être couplé à la seconde connexion du transistor ;
un dispositif (20 ; 20') destiné à fournir un courant continu (I_{DC}) entre deux connexions, une connexion étant reliée au noeud de sortie (19) et l'autre connexion au second noeud (18 ; 18') ;
un premier interrupteur (24) qui est normalement ouvert et qui peut être réglé (Φ₁) pour relier, dans un état fermé, le noeud de sortie (19), au moins pendant une partie du segment ne portant pas d'informations (38) de l'intervalle (30, 32, 34, 36), à un noeud de référence (26 ; 26'), pour générer un potentiel de référence au noeud de sortie (19) du circuit ; et
un second interrupteur (12) qui est connecté entre la seconde connexion du transistor (10; 10'; 10''; 10''') et le premier noeud (16; 16') et qui peut être réglé pour interrompre une connexion électroconductrice entre le premier noeud (16; 16') et la seconde connexion (10b; 10b'; 10b''; 10b''') du transistor (10; 10' ; 10''; 10''') au moins tant que le premier interrupteur (24) relie la troisième connexion (10c; 10c'; 10c''; 10c''') du transistor au noeud de référence (26 ; 26').

2. Circuit pour le traitement d'un signal analogique présentant une succession dans le temps de niveaux de signal discret, chaque niveau de signal discret étant situé dans un intervalle de temps (30 à 36) et représentant un segment portant des informations de l'intervalle, tandis que le reste (38) de l'intervalle est un segment ne portant pas d'informations, aux caractéristiques suivantes :
un transistor (10; 10'; 10" ; 10"') avec une première (10a; 10a'; 10a''; 10a'''), une seconde (10b; 10b'; 10b''; 10b''') et une troisième connexion (10c; 10c'; 10c'''; 10c'''), le transistor étant disposé de telle sorte que par un signal à la première connexion peut être réglé un flux de courant entre la seconde et la troisième connexion, que le signal analogique discret dans le temps (Uₑ) peut être appliqué à la première connexion et que la troisième connexion peut être couplée à un noeud de sortie (19) du circuit ;
un dispositif (14) destiné à appliquer une tension entre un premier noeud (16 ; 16') avec un premier potentiel (U_{B} ; 0V) et un second noeud (18 ; 18') avec un second potentiel (0V ; U_{B}), le premier noeud (16) pouvant être couplé à la seconde connexion du transistor ;
un dispositif (20 ; 20') destiné à fournir un courant continu (I_{DC}) entre deux connexions, une connexion étant reliée au noeud de sortie (19) et l'autre connexion au second noeud (18 ; 18') ;
un premier interrupteur (24) qui est normalement ouvert et qui peut être réglé (Φ₁) pour relier, dans un état fermé, le noeud de sortie (19), au moins pendant une partie du segment ne portant pas d'informations (38) de l'intervalle (30, 32, 34, 36), à un noeud de référence (26 ; 26'), pour générer un potentiel de référence au noeud de sortie (19) du circuit ; et
un second interrupteur (12) qui est connecté entre la troisième connexion (10c ; 10c' ; 10c" ; 10c''') du transistor et le noeud de sortie (19) du circuit, le second interrupteur (12) pouvant être réglé pour interrompre une connexion électroconductrice entre le noeud de sortie (19) et la troisième connexion du transistor au moins tant que le premier interrupteur (24) relie le noeud de sortie au second noeud.

3. Circuit selon l'une des revendications précédentes, dans lequel le noeud de référence (26 ; 26') est relié de manière électroconductrice au second noeud (18 ; 18'), de sorte que le potentiel au noeud de référence (26 ; 26') soit égal au potentiel (0V : U_{B}) au second noeud (18 ; 18').

4. Circuit selon la revendication 1 ou 2, dans lequel le noeud de référence (26 ; 26') est une connexion d'un condensateur qui est chargé pour générer le potentiel de référence.

5. Circuit selon la revendication 1 ou 2, dans lequel le noeud de référence (26 ; 26') est une connexion d'une alimentation de tension qui se distingue d'une alimentation de tension pouvant être reliée au dispositif (14) destiné à appliquer une tension.

6. Circuit selon l'une des revendications précédentes, dans lequel les intervalles du signal analogique (30, 32, 34, 36) présentent une longueur constante définissant une fréquence d'impulsion d'horloge (f_{CLK}) d'un signal d'horloge et dans lequel le premier interrupteur peut être commandé par une commande (Φ₁) qui est dérivé du signal d'horloge.

7. Circuit selon l'une des revendications précédentes, dans lequel le dispositif (20 ; 20') destiné à fournir un courant continu (I_{DC}) est une source de courant constant à haute résistance intérieure ou une résistance hautement ohmique.

8. Circuit selon l'une des revendications précédentes,
dans lequel le transistor (10) est un transistor npn, la première connexion (10a) étant une connexion de base, la seconde connexion (10b) étant une connexion de collecteur et la troisième connexion (10c) étant une connexion d'émetteur, et
dans lequel le dispositif (14) destiné à appliquer une tension est disposé de manière à générer, au premier noeud (16), un potentiel positif (U_{B}) et, au second noeud (18), un potentiel de masse (0V).

9. Circuit selon l'une des revendications 1 à 8,
dans lequel le transistor (10) est un transistor à effet de champ à n canaux, la première connexion (10a') étant une connexion de porte du transistor, la seconde connexion (10b') étant une connexion de drain du transistor et la troisième connexion (10c') étant une connexion de source du transistor, et
dans lequel le dispositif (14) destiné à appliquer une tension est disposé de manière à générer, au premier noeud (16), un potentiel positif (U_{B}) et, au second noeud (18), un potentiel de masse (0V).

10. Circuit selon l'une des revendications 8 ou 9, dans lequel le premier interrupteur (24) est disposé de manière à être fermé au moins jusqu'à ce que le potentiel au noeud de sortie (19) soit inférieur ou égal à un niveau de signal discret du signal analogique le plus bas pouvant être attendu.

11. Circuit selon l'une des revendications 8 ou 9,
dans lequel le noeud de référence (26) est inférieur ou égal au niveau de signal discret du signal analogique le plus bas pouvant être attendu, et
dans lequel l'interrupteur (24) est disposé de manière à être fermé jusqu'à ce que le potentiel au noeud de sortie ait, comme potentiel de référence, le potentiel du noeud de référence (26).

12. Circuit selon l'une des revendications 1 à 7,
dans lequel le transistor est un transistor pnp (10"), la première connexion (10a'') étant une base du transistor, la seconde connexion (10b'') étant un collecteur du transistor et la troisième connexion (10c'') étant un émetteur du transistor, et
dans lequel le dispositif (14) destiné à appliquer une tension est disposé de manière à générer, au premier noeud (16), un potentiel de masse (0V) et, au second noeud (18), un potentiel d'alimentation de tension positif (U_{B}).

13. Circuit selon l'une des revendications 1 à 7,
dans lequel le transistor est un transistor à effet de champ à n canaux (10"'), la première connexion (10a''') étant une connexion de porte du transistor, la seconde connexion (10b''') étant une connexion de drain du transistor et la troisième connexion (10c''') étant une connexion de source du transistor, et
dans lequel le dispositif (14) destiné à appliquer une tension est disposé de manière à générer, au premier noeud (16'), un potentiel de masse (0V) et, au second noeud (18'), un potentiel d'alimentation de tension positif (U_{B}).

14. Circuit selon la revendication 12 ou 13, dans lequel le premier interrupteur (24) est disposé de manière à être fermé au moins jusqu'à ce que le potentiel au noeud de sortie (19) soit supérieur ou égal au niveau de signal discret le plus élevé pouvant être attendu.

15. Circuit selon la revendication 12 ou 13,
dans lequel un signal applicable au noeud de référence (26') est supérieur ou égal au niveau de signal discret du signal analogique le plus élevé pouvant être attendu, et
dans lequel le premier interrupteur (24) est disposé de manière à être fermé jusqu'à ce que le potentiel de référence au noeud de sortie (19) du circuit soit le potentiel désiré.

16. Circuit selon l'une des revendications précédentes, présentant, par ailleurs, une capacité (C_{L}) entre le noeud de sortie (19) du circuit et le second noeud.

17. Capteur d'images avec une pluralité d'éléments de pixel (P1 à P5), aux caractéristiques suivantes :
un dispositif (60) destiné à lire la pluralité d'éléments de pixel (P1 à P5), pour fournir un signal analogique (Uₑ) présentant une succession dans le temps de niveaux de signal discret ;
un circuit (62) destiné à traiter le signal analogique selon l'une des revendications 1 à 15, pour fournir un signal de sortie (Uₐ) correspondant au signal d'entrée (Uₑ) ; et
une capacité (64) disposée en parallèle avec une sortie du circuit (62).

18. Capteur d'images, aux caractéristiques suivantes :
une pluralité d'éléments de pixel (P1 à PN), chaque élément de pixel présentant les caractéristiques suivantes :
un transistor (10; 10'; 10" ; 10"') avec une première (10a; 10a'; 10a''; 10a'''), une seconde (10b; 10b'; 10b''; 10b''') et une troisième connexion (10c; 10c'; 10c''; 10c'''), le transistor étant disposé de telle sorte que par un signal à la première connexion peut être réglé un flux de courant entre la seconde et la troisième connexion, qu'un signal de pixel (Uₑ₁, Uₑ₂, ..., U_{eN}) peut être appliqué à la première connexion et que la troisième connexion peut être couplée à un noeud de sortie (19) du capteur d'images ;
un dispositif (14) destiné à appliquer une tension entre un premier noeud (16 ; 16') avec un premier potentiel (U_{B} ; 0V) et un second noeud (18 ; 18') avec un second potentiel (0V ; U_{B}), le premier noeud (16) pouvant être couplé à la seconde connexion du transistor ; et
un second interrupteur (SEL1, SEL2, ..., SELN) avec une première et une seconde connexion, la première connexion du second interrupteur étant reliée à la troisième connexion (10c; 10c'; 10c''; 10c''') du transistor et le second interrupteur (12) pouvant être réglé de manière à coupler sa seconde connexion à la troisième connexion du transistor ;
une ligne de sortie commune à la pluralité d'éléments de pixel qui est reliée au noeud de sortie (19) du capteur d'images et aux secondes connexions des seconds interrupteurs (SEL1, SEL2, ..., SELN) des éléments de pixel ;
un dispositif (20; 20') destiné à fournir un courant continu (I_{DC}) entre deux connexions, une connexion étant reliée à la ligne de sortie et l'autre connexion étant reliée au second noeud (18; 18');
un premier interrupteur (24) qui est normalement ouvert et qui peut être réglé (Φ₁) pour relier, dans un état fermé, la ligne de sortie commune d'au moins une partie d'un segment ne portant pas d'informations (38) d'un signal de pixel (Uₑ₁, Uₑ₂, ..., U_{eN}) à un noeud de référence (26 ; 26'), pour générer un potentiel de référence au noeud de sortie (19) du capteur d'images ; et
un dispositif (60) destiné à lire en série la pluralité d'éléments de pixel en réglant le second interrupteur (SEL1, SEL2, SELN) qui est disposé de manière, pour fournir le signal de pixel (Uₑ₁) d'un élément de pixel (SEL1) au noeud de sortie (19), à ne fermer que le second interrupteur (SEL1) de cet élément de pixel (PIXEL 1), tandis que les seconds interrupteurs (SEL2, ... SLEN) des autres éléments de pixel (PIXEL 2, ..., PIXEL N) sont ouverts.

## Revendications (Revendications pour l'(les) Etat(s) contractant(s) suivant(s): DE, FR, GB, IT, NL)

1. Circuit pour le traitement d'un signal analogique présentant une succession dans le temps de niveaux de signal discret, chaque niveau de signal discret étant situé dans un intervalle de temps (30 à 36) et représentant un segment portant des informations de l'intervalle, tandis que le reste (38) de l'intervalle est un segment ne portant pas d'informations, aux caractéristiques suivantes :
un transistor (10 ; 10' ; 10" ; 10"') avec une première (10a; 10a'; 10a''; 10a'''), une seconde (10b; 10b'; 10b''; 10b''') et une troisième connexion (10c; 10c'; 10c''; 10c'''), le transistor étant disposé de telle sorte que par un signal à la première connexion peut être réglé un flux de courant entre la seconde et la troisième connexion, que le signal analogique discret dans le temps (Uₑ) peut être appliqué à la première connexion et que la troisième connexion peut être couplée à un noeud de sortie (19) du circuit ;
un dispositif (14) destiné à appliquer une tension entre un premier noeud (16 ; 16') avec un premier potentiel (U_{B} ; 0V) et un second noeud (18 ; 18') avec un second potentiel (0V ; U_{B}), le premier noeud (16) pouvant être couplé à la seconde connexion du transistor ;
un dispositif (20 ; 20') destiné à fournir un courant continu (I_{DC}) entre deux connexions, une connexion étant reliée au noeud de sortie (19) et l'autre connexion au second noeud (18; 18');
un premier interrupteur (24) qui est normalement ouvert et qui peut être réglé (Φ₁) pour relier, dans un état fermé, le noeud de sortie (19), au moins pendant une partie du segment ne portant pas d'informations (38) de l'intervalle (30, 32, 34, 36), à un noeud de référence (26 ; 26'), pour générer un potentiel de référence au noeud de sortie (19) du circuit ; et
un second interrupteur (12) qui est connecté entre la seconde connexion du transistor (10; 10'; 10" ; 10"') et le premier noeud (16; 16') et qui peut être réglé pour interrompre une connexion électroconductrice entre le premier noeud (16; 16') et la seconde connexion (10b ; 10b' ; 10b" ; 10b''') du transistor (10 ; 10' ; 10" ; 10"') au moins tant que le premier interrupteur (24) relie la troisième connexion (10c ; 10c' ; 10c'' ; 10c''') du transistor au noeud de référence (26 ; 26'),
le circuit présentant, par ailleurs, une capacité de charge (C_{L}) entre le noeud de sortie (19) et le second noeud, de sorte qu'un état de chargement de la capacité de charge (C_{L}) puisse être influencé par la fermeture du premier interrupteur (24).

2. Circuit pour le traitement d'un signal analogique présentant une succession dans le temps de niveaux de signal discret, chaque niveau de signal discret étant situé dans un intervalle de temps (30 à 36) et représentant un segment portant des informations de l'intervalle, tandis que le reste (38) de l'intervalle est un segment ne portant pas d'informations, aux caractéristiques suivantes :
un transistor (10; 10'; 10''; 10"') avec une première (10a; 10a'; 10a''; 10a'''), une seconde (10b; 10b'; 10b''; 10b''') et une troisième connexion (10c; 10c'; 10c''; 10c'''), le transistor étant disposé de telle sorte que par un signal à la première connexion peut être réglé un flux de courant entre la seconde et la troisième connexion, que le signal analogique discret dans le temps (Uₑ) peut être appliqué à la première connexion et que la troisième connexion peut être couplée à un noeud de sortie (19) du circuit;
un dispositif (14) destiné à appliquer une tension entre un premier noeud (16 ; 16') avec un premier potentiel (U_{B} ; 0V) et un second noeud (18 ; 18') avec un second potentiel (0V ; U_{B}), le premier noeud (16) pouvant être couplé à la seconde connexion du transistor ;
un dispositif (20; 20') destiné à fournir un courant continu (I_{DC}) entre deux connexions, une connexion étant reliée au noeud de sortie (19) et l'autre connexion au second noeud (18 ; 18') ;
un premier interrupteur (24) qui est normalement ouvert et qui peut être réglé (Φ₁) pour relier, dans un état fermé, le noeud de sortie (19), au moins pendant une partie du segment ne portant pas d'informations (38) de l'intervalle (30, 32, 34, 36), à un noeud de référence (26 ; 26'), pour générer un potentiel de référence au noeud de sortie (19) du circuit ; et
un second interrupteur (12) qui est connecté entre la troisième connexion (10c; 10c'; 10c''; 10c''') du transistor et le noeud de sortie (19) du circuit, le second interrupteur (12) pouvant être réglé pour interrompre une connexion électroconductrice entre le noeud de sortie (19) et la troisième connexion du transistor au moins tant que le premier interrupteur (24) relie le noeud de sortie au second noeud,
le circuit présentant, par ailleurs, une capacité de charge (C_{L}) entre le noeud de sortie (19) et le second noeud, de sorte qu'un état de chargement de la capacité de charge (C_{L}) puisse être influencé par la fermeture du premier interrupteur (24).

3. Circuit selon l'une des revendications précédentes, dans lequel le noeud de référence (26 ; 26') est relié de manière électroconductrice au second noeud (18 ; 18'), de sorte que le potentiel au noeud de référence (26 ; 26') soit égal au potentiel (0V : U_{B}) au second noeud (18 ; 18').

4. Circuit selon la revendication 1 ou 2, dans lequel le noeud de référence (26 ; 26') est une connexion d'un condensateur qui est chargé pour générer le potentiel de référence.

5. Circuit selon la revendication 1 ou 2, dans lequel le noeud de référence (26 ; 26') est une connexion d'une alimentation de tension qui se distingue d'une alimentation de tension pouvant être reliée au dispositif (14) destiné à appliquer une tension.

6. Circuit selon l'une des revendications précédentes, dans lequel les intervalles du signal analogique (30, 32, 34, 36) présentent une longueur constante définissant une fréquence d'impulsion d'horloge (f_{CLK}) d'un signal d'horloge et dans lequel le premier interrupteur peut être commandé par un signal de commande (Φ₁) qui est dérivé du signal d'horloge.

7. Circuit selon l'une des revendications précédentes, dans lequel le dispositif (20; 20') destiné à fournir un courant continu (I_{DC}) est une source de courant constant à haute résistance intérieure ou une résistance hautement ohmique.

8. Circuit selon l'une des revendications précédentes,
dans lequel le transistor (10) est un transistor npn, la première connexion (10a) étant une connexion de base, la seconde connexion (10b) étant une connexion de collecteur et la troisième connexion (10c) étant une connexion d'émetteur, et
dans lequel le dispositif (14) destiné à appliquer une tension est disposé de manière à générer, au premier noeud (16), un potentiel positif (U_{B}) et, au second noeud (18), un potentiel de masse (0V).

9. Circuit selon l'une des revendications 1 à 8,
dans lequel le transistor (10) est un transistor à effet de champ à n canaux, la première connexion (10a') étant une connexion de porte du transistor, la seconde connexion (10b') étant une connexion de drain du transistor et la troisième connexion (10c') étant une connexion de source du transistor, et
dans lequel le dispositif (14) destiné à appliquer une tension est disposé de manière à générer, au premier noeud (16), un potentiel positif (U_{B}) et, au second noeud (18), un potentiel de masse (0V).

10. Circuit selon l'une des revendications 8 ou 9, dans lequel le premier interrupteur (24) est disposé de manière à être fermé au moins jusqu'à ce que le potentiel au noeud de sortie (19) soit inférieur ou égal à un niveau de signal discret du signal analogique le plus bas pouvant être attendu.

11. Circuit selon l'une des revendications 8 ou 9,
dans lequel le noeud de référence (26) est inférieur ou égal au niveau de signal discret du signal analogique le plus bas pouvant être attendu, et
dans lequel l'interrupteur (24) est disposé de manière à être fermé jusqu'à ce que le potentiel au noeud de sortie ait, comme potentiel de référence, le potentiel du noeud de référence (26).

12. Circuit selon l'une des revendications 1 à 7,
dans lequel le transistor est un transistor pnp (10"), la première connexion (10a'') étant une base du transistor, la seconde connexion (10b'') étant un collecteur du transistor et la troisième connexion (10c'') étant un émetteur du transistor, et
dans lequel le dispositif (14) destiné à appliquer une tension est disposé de manière à générer, au premier noeud (16), un potentiel de masse (0V) et, au second noeud (18), un potentiel d'alimentation de tension positif (U_{B}).

13. Circuit selon l'une des revendications 1 à 7,
dans lequel le transistor est un transistor à effet de champ à n canaux (10"'), la première connexion (10a''') étant une connexion de porte du transistor, la seconde connexion (10b''') étant une connexion de drain du transistor et la troisième connexion (10c''') étant une connexion de source du transistor, et
dans lequel le dispositif (14) destiné à appliquer une tension est disposé de manière à générer, au premier noeud (16'), un potentiel de masse (0V) et, au second noeud (18'), un potentiel d'alimentation de tension positif (U_{B}).

14. Circuit selon la revendication 12 ou 13, dans lequel le premier interrupteur (24) est disposé de manière à être fermé au moins jusqu'à ce que le potentiel au noeud de sortie (19) soit supérieur ou égal au niveau de signal discret le plus élevé pouvant être attendu.

15. Circuit selon la revendication 12 ou 13,
dans lequel un signal applicable au noeud de référence (26') est supérieur ou égal au niveau de signal discret du signal analogique le plus élevé pouvant être attendu, et
dans lequel le premier interrupteur (24) est disposé de manière à être fermé jusqu'à ce que le potentiel de référence au noeud de sortie (19) du circuit soit le potentiel désiré.

16. Capteur d'images avec une pluralité d'éléments de pixel (P1 à P5), aux caractéristiques suivantes :
un dispositif (60) destiné à lire la pluralité d'éléments de pixel (P1 à P5), pour fournir un signal analogique (Uₑ) présentant une succession dans le temps de niveaux de signal discret ;
un circuit (62) destiné à traiter le signal analogique selon l'une des revendications 1 à 15, pour fournir un signal de sortie (Uₐ) correspondant au signal d'entrée (Uₑ); et
une capacité de charge (64) connectée entre une sortie du circuit (62) et un second noeud du circuit, de sorte qu'un état de chargement de la capacité de charge (C_{L}) puisse être influencé par la fermeture d'un premier interrupteur (24) du circuit de traitement.

17. Capteur d'images, aux caractéristiques suivantes :
une pluralité d'éléments de pixel (P1 à PN), chaque élément de pixel présentant les caractéristiques suivantes:
un transistor (10; 10'; 10''; 10"') avec une première (10a; 10a'; 10a''; 10a'''), une seconde (10b; 10b'; 10b''; 10b''') et une troisième connexion (10c; 10c'; 10c''; 10c'''), le transistor étant disposé de telle sorte que par un signal à la première connexion peut être réglé un flux de courant entre la seconde et la troisième connexion, qu'un signal de pixel (Uₑ₁, Uₑ₂, ..., U_{eN}) peut être appliqué à la première connexion et que la troisième connexion peut être couplée à un noeud de sortie (19) du capteur d'images ;
un dispositif (14) destiné à appliquer une tension entre un premier noeud (16 ; 16') avec un premier potentiel (U_{B} ; 0V) et un second noeud (18 ; 18') avec un second potentiel (0V ; U_{B}), le premier noeud (16) pouvant être couplé à la seconde connexion du transistor ; et
un second interrupteur (SEL1, SEL2, ..., SELN) avec une première et une seconde connexion, la première connexion du second interrupteur étant reliée à la troisième connexion (10c; 10c'; 10c''; 10c''') du transistor et le second interrupteur (12) pouvant être réglé de manière à coupler sa seconde connexion à la troisième connexion du transistor ;
une ligne de sortie commune à la pluralité d'éléments de pixel qui est reliée au noeud de sortie (19) du capteur d'images et aux secondes connexions des seconds interrupteurs (SEL1, SEL2, ..., SELN) des éléments de pixel ;
un dispositif (20 ; 20') destiné à fournir un courant continu (I_{DC}) entre deux connexions, une connexion étant reliée à la ligne de sortie et l'autre connexion étant reliée au second noeud (18 ; 18') ;
un premier interrupteur (24) qui est normalement ouvert et qui peut être réglé (Φ₁) pour relier, dans un état fermé, la ligne de sortie commune d'au moins une partie d'un segment ne portant pas d'informations (38) d'un signal de pixel (Uₑ₁, Uₑ₂, ..., U_{eN}) à un noeud de référence (26 ; 26'), pour générer un potentiel de référence au noeud de sortie (19) du capteur d'images ; et
un dispositif (60) destiné à lire en série la pluralité d'éléments de pixel en réglant le second interrupteur (SEL1, SEL2, SELN) qui est disposé de manière, pour fournir le signal de pixel (Uₑ₁) d'un élément de pixel (SEL1) au noeud de sortie (19), à ne fermer que le second interrupteur (SEL1) de cet élément de pixel (PIXEL 1), tandis que les seconds interrupteurs (SEL2, ... SLEN) des autres éléments de pixel (PIXEL 2, ..., PIXEL N) sont ouverts,
une capacité de charge (C_{L}) étant, par ailleurs, connectée entre le noeud de sortie (19) et le second noeud, de sorte qu'un état de chargement de la capacité de charge (C_{L}) puisse être influencé par la fermeture du premier interrupteur (24).
